# EUROPEAN PATENT SPECIFICATION

(11) **EP 4 396 259 B1**
(45) Date of publication and mention of the grant of the patent: **04.02.2026**
(21) Application number: 22769658.0
(22) Date of filing: 29.08.2022
(51) Int. Cl.: C08G 61/08, C08L 65/00, C09D 165/00, H10K 85/60

(54) **COMPOSITION**
ZUSAMMENSETZUNG
COMPOSITION

(30) Priority: 31.08.2021 EP 21193975
(43) Date of publication of application: 10.07.2024
(73) Proprietor: Merck Patent GmbH, 64293 Darmstadt (DE)
(72) Inventor: MISKIEWICZ, Pawel, 64293 DARMSTADT (DE); HAMBURGER, Manuel, 64293 DARMSTADT (DE); YOON, Hyun-Jin, PYEONGTAEK 17956 (KR)
(74) Representative: Merck Patent Association
(86) International application number: PCT/EP2022/073871
(87) International publication number: WO 2023/031073

(56) References cited:
- WO-A1-2021/072206
- WO-A1-2021/138651
- WO-A1-99/00397
- US-A1- 2021 079 133
- ALLEN N S ET AL: "PHOTOCHEMISTRY AND PHOTOCURING ACTIVITY OF NOVEL 1-HALOGENO-4-PROPOXYTHIOXANTHONES", JOURNAL OF THE CHEMICAL SOCIETY. FARADAY TRANSACTIONS, ROYAL SOCIETY OF CHEMISTRY, CAMBRIDGE, GB, vol. 90, no. 1, 7 January 1994 (1994-01-07), pages 83 - 92, XP000420750, ISSN: 0956-5000, DOI: 10.1039/FT9949000083

## Description

### Technical Field

The present application relates to a composition comprising (a) monomers, (b) a metal catalyst, (c) a compound capable of releasing a Bronsted acid and (d) an absorber; using thereof; manufacturing a polycycloolefin layer; and manufacturing an electronic device.

### Background

Electronic devices, and particularly organic electronic devices, have become thinner and thinner over the years, thereby now allowing for devices that can be rolled or bent. This development has led to the development and recent market introduction of, for example, smartphones with foldable displays based on organic light emitting device technology.

However, such devices are sensitive to environmental influences, especially to oxygen and moisture. If not protected, their performance will degrade over time, in some instances even rather quickly.

Additionally, the mechanical stresses induced by folding and bending may also lead to fractures in any of the device layers directly in or in proximity to the fold or bend.

Under such circumstance, several trials are done as following Patent documents.

In Patent document 1, certain cycloolefin monomers are studied to make layers to obtain improved optical property.

In Patent document 2, Compositions having certain latent catalyst and compound capable of generating a Bronsted acid are studied as suitable ink composition for 3D object.

In Patent document 3, a single component composition which is able to undergo mass polymerization under the OLED device fabrication conditions is provided. Moreover, a composition having certain cycloolefin monomer, catalyst and a compound capable of releasing a Bronsted acid is studied.

In Patent document 4, a stable single component mass polymerizable composition is provided, which shows no change in viscosity at or below normal storage conditions, but which undergoes mass polymerization only under the process conditions where an OLED device is finally fabricated, such as, for example, by the use of radiation and/or thermal process.

In Patent document 5, polycycloolefin polymer is studied to be used in organic electronic device, which can possess low dielectric property.

Patent document 6 discloses a method for generating a polymer, comprising:
(a) providing a mixture comprising
   (i) a latent ruthenium (Ru) complex;
   (ii) an initiator;
   (iii) a sensitizer that sensitizes said initiator; and
   (iv) at least one polymer precursor; and
(b) exposing said mixture to electromagnetic radiation to activate said initiator, wherein upon activation, said initiator reacts with said latent Ru complex to generate an activated Ru complex, which activated Ru complex reacts with said at least one polymer precursor to generate at least a portion of said polymer.

Patent document 7 teaches a process for preparing metathesis polymers, which comprises heating a composition comprising
(a) dicyclopentadiene or another strained cycloolefin, or dicyclopentadiene in a mixture with another strained cycloolefin, and
(b) a catalytic amount of at least one compound of the formula I 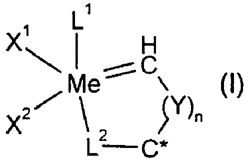
   and isomers of these compounds and, if desired, further additives for polymers
   and, if desired, subjecting the obtainable metathesis polymer to a shaping process.

Patent document 8 discloses a composition comprising a) one or more cyclic olefin-based monomers, b) a latent organo-ruthenium carbide catalyst, c) a photoactive or a thermoactive acid generator; and d) a photoactive compound.

Patent document 9 discloses a composition comprising a) one or more cyclic olefin-based monomers, b) an organo-ruthenium carbide catalyst, c) an (aromatic) amine; and d) a thioxanthone-based photoactive compound.

Non-patent document 10 states that substitution of a chloro or bromo atom in the 1-position of thioxanthone results in the formation of a photoinitiator which operates without the need for a cosynergist, unlike commercial thioxanthones which require the use of a tertiary amine cosynergist.

### Prior art documents

[Patent document 1] WO2020/002277 A1
[Patent document 2] US2020/002466 A1
[Patent document 3] US 2019/0232267 A1
[Patent document 4] US2019/048130 A1
[Patent document 5] WO2015/135622 A1
[Patent document 6] WO2021/072206 A1
[Patent document 7] WO99/00397 A1
[Patent document 8] US 2021/079133 A1
[Patent document 9] WO 2021/138651 A1
[Non-patent document 10] J. Chem. Soc. Faraday Trans., 1994, 90(1), 83-92

### Summary

### PROBLEMS TO BE SOLVED BY THE INVENTION

The present inventors considered that one or more technical problems still need to be improved.

Examples of these include the followings: to obtain a polycycloolefin layer transparent in visible wavelength; to obtain a polycycloolefin layer which blocks invisible wavelength; to use narrower wavelength exposure to cure the layer, though an absorber absorbs certain light; to obtain a polycycloolefin layer to protect an underlayer or underlying base member from damage; to obtain a polycycloolefin layer with good permittivity or useful for encapsulation layer or insulation layer; to obtain a polycycloolefin layer with good flexibility or useful for flexible display device; to obtain a clear composition with good solubility of solute; to obtain a stable composition (e.g., capable of avoiding turbid); to obtain a composition with good processability by printing or coating; to obtain a composition with good wettability even on a wide substrate; and/or to obtain a smooth, homogenous, closed or pinhole-free polycycloolefin layer.

### MEANS FOR SOLVING THE PROBLEMS

The present application provides a composition comprising (a) one or more monomers of formula (I); (b) a latent organo-transition metal catalyst comprising a metal selected from the group consisting of ruthenium, osmium or palladium; (c) a compound capable of releasing a Bronsted acid when subjected to photolytic conditions; and (d) an absorber compound having a maximum absorption wavelength between 280-410 nm;
wherein the formula (I) is represented by below formula. 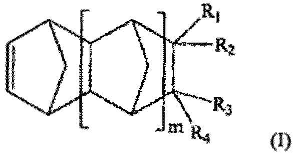
wherein the (c) compound capable of generating Bronsted acid when subjected to photolytic conditions is of the formula (V): 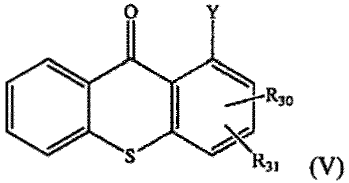 ; and
wherein the (d) absorber compound is represented by a formula selected from the group consisting of the following formula (d-1), (d-2) and (d-3) or the (d) absorber compound is a compound selected from the group consisting of aromatic tertiary amines containing at least two tertiary amine units, tertiary amines containing carbazole units, hexa-aza-triphenylene compounds and phthalocyanine derivatives;

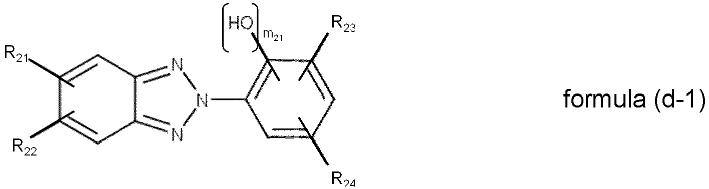

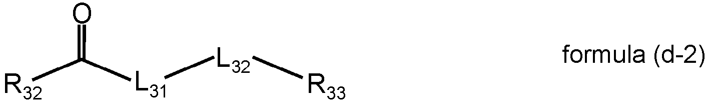

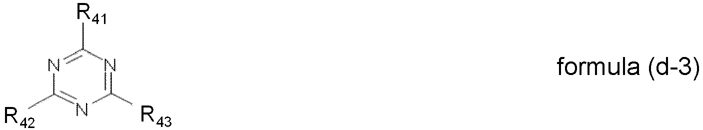

### Detailed descriptions of each elements follow.

Also, the present application provides a method of manufacturing a polycycloolefin layer comprising steps of; (1) preparing a base member; (2) applying the composition according to this invention above the base member; and (3) polymerizing the (a) monomers in the composition.

As another embodiment, the present application provides a method of manufacturing an electronic device comprising a method of manufacturing a polycycloolefin layer of this invention. As one another aspect of this invention, the present application also provides an electronic device manufactured by the method of this invention.

### EFFECTS OF THE INVENTION

Using the composition and/or the method according to the present invention, it is possible to expect one or more of the following effects.

It is possible to obtain a polycycloolefin layer transparent in visible wavelength. It is possible to obtain a polycycloolefin layer which blocks invisible wavelength (e.g., the area of narrower wavelength; UV wavelength). It is possible to use narrower wavelength (e.g., UV) exposure to cure the layer, though (d) absorber has absorption around this wavelength. It is possible to obtain a polycycloolefin layer to protect an underlayer or underlying base member from damage caused by narrower wavelength exposure (e.g., UV). It is possible to obtain a polycycloolefin layer to protect an underlayer or underlying base member from water, oxygen, or dust. It is possible to obtain a polycycloolefin layer which exhibits good permittivity and can be useful for encapsulation layer or insulation layer. It is possible to obtain a polycycloolefin layer which exhibit good flexibility and can be useful for flexible display device. It is possible to obtain a clear composition in which solubility of solute is good. It is possible to obtain a stable composition which can avoid turbid. It is possible to obtain a composition which can exhibit good processability by printing or coating. It is possible to obtain a composition which can exhibit good wettability even on a wide substrate (e.g., in a display device). It is possible to obtain a smooth, homogenous, closed or pinhole-free polycycloolefin layer.

### Detailed description

Embodiments of the present invention are described below in detail.

### [Definitions]

Unless otherwise specified in the present specification, the definitions and examples described in this paragraph are followed.

The singular form includes the plural form and "one" or "that" means "at least one". An element of a concept can be expressed by a plurality of species, and when the amount (for example, mass% or mol%) is described, it means sum of the plurality of species.

"And/or" includes a combination of all elements and also includes single use of the element.

When a numerical range is indicated using "to" or "-", it includes both endpoints and units thereof are common. For example, 5 to 25 mol% means 5 mol% or more and 25 mol% or less.

The descriptions such as "C_{x-y}", "Cₓ-C_{y}" and "Cₓ" mean the number of carbons in a molecule or substituent. For example, C₁₋₆ alkyl means an alkyl chain having 1 or more and 6 or less carbons (methyl, ethyl, propyl, butyl, pentyl, hexyl etc.).

When polymer has a plural types of repeating units, these repeating units copolymerize. These copolymerization may be any of alternating copolymerization, random copolymerization, block copolymerization, graft copolymerization, or a mixture thereof. When polymer or resin is represented by a structural formula, n, m or the like that is attached next to parentheses indicate the number of repetitions.

Celsius is used as the temperature unit. For example, 20 degrees means 20 degrees Celsius.

The additive refers to a compound itself having a function thereof (for example, in the case of a base generator, the compound itself that generates a base). An aspect in which the compound is dissolved or dispersed in a solvent and added to the composition is also possible. As one embodiment of the present invention, it is preferable that such a solvent is contained in the composition of this invention as a solvent of additive.

In general terms, the present application relates to a composition comprising (a) a monomer(s), (b) a metal catalyst, (c) a compound capable to release a Bronsted acid, and (d) an absorber. It is noted that for the purposes of the present application the terms "cycloolefin" and "polycycloolefin" can be preferably each denoted as "norbornene" and "polynorbornene".

### [Composition]

Present invention provides a composition comprising (a) one or more monomers of formula (I); (b) a latent organo-transition metal catalyst comprising a metal selected from the group consisting of ruthenium, osmium or palladium; (c) a compound capable of releasing a Bronsted acid when subjected to photolytic conditions; and (d) an absorber compound having a maximum absorption wavelength between 280-410 nm. The composition can be preferably a polycycloolefin layer forming composition (more preferably a polycycloolefin layer forming composition transparent of visible light). A polycycloolefin layer forming composition can consist of the composition according to the present invention. Each component is followingly described in detail.

The viscosity of the composition of this invention can be preferably 5-20 mPass (more preferably 5-15 mPass; further preferably 5-12 mPass). The viscosity can be measured by known method. The temperature to measure a viscosity of the composition of this invention can be preferably 20-40 °C (more preferably 25-40 °C; further preferably at 40 °C).

The surface tension of the composition of this invention can be preferably 10-50 mN/m (more preferably 20-40 mN/m; further preferably 25-40 mN/m) at 25 °C. The surface tension can be measured by known method. Without wishing to be bound by theory, the composition of this invention can exhibit good processability by printing and coating techniques, good wetting on a wide range of substrate materials and/or enable to obtain smooth, homogenous, closed and/or pinhole-free films when applied to a base member.

### [(a) monomer]

The composition of the present invention comprises (a) one or more monomers of formula (I); wherein the formula (I) is represented by below formula. 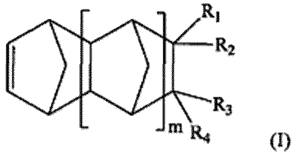 m is an integer 0, 1 or 2 (preferably 0 or 1). As one preferable embodiment of this invention, m is 1. As another preferable embodiment of this invention, m is 0.

R₁, R₂, R₃ and R₄ are each independently selected from the group consisting of hydrogen, halogen, methyl, ethyl, linear or branched C₁₋₂₀ alkyl, perfluoro C₁₋₁₂ alkyl, hydroxy C₁₋₁₆ alkyl, C₃₋₁₂ cycloalkyl, C₆₋₁₂ bicycloalkyl, (CH₂)ₐ- C₆₋₁₂ bicycloalkenyl, C₇₋₁₄ tricycloalkyl, substituted or unsubstituted C₆₋₁₀ aryl, substituted or unsubstituted C₆₋₁₀ aryl C₁₋₆ alkyl, perfluoro C₆₋₁₀ aryl, perfluoro C₆₋₁₀ aryl C₁₋₃ alkyl and a group of formula (A):

-Z-Aryl (A).
R₁, R₂, R₃ and R₄ are each independently preferably selected from the group consisting of hydrogen, ethyl, linear or branched C₃₋₈ alkyl,
substituted or unsubstituted C₆₋₁₀ aryl C₁₋₆ alkyl, and a group of formula (A); more preferably selected from the group consisting of hydrogen, ethyl, linear or branched C₃₋₈ alkyl, and unsubstituted C₆₋₁₀ aryl C₁₋₆ alkyl.

As one preferred embodiment of this invention R₂, R₃ and R₄ are hydrogen. As one preferred embodiment of this invention R₁ is not hydrogen.

Z is a single bond or a group selected from the group consisting of: (CR₅R₆)ₐ, O(CR₅R₆)ₐ, (CR₅R₆)ₐO, (CR₅R₆)ₐ-O-(CR₅R₆)_{b}, (CR₅R₆)ₐ-O-(SiR₅R₆)_{b}, (CR₅R₆)ₐ-(CO)O-(CR₅R₆)_{b}. Z is preferably (CR₅R₆)ₐ. a and b are integers each independently is 1 to 12 (preferably 1 to 3; more preferably 1 or 2; further preferably 2).

Rs and R₆ are each independently selected from the group consisting of hydrogen, methyl, ethyl, linear or branched C₃₋₆ alkyl, hydroxy, methoxy, ethoxy, linear or branched C₃₋₆ alkyloxy, acetoxy, C₂₋₆ acyl, hydroxymethyl, hydroxyethyl, linear or branched hydroxy C₃₋₆ alkyl, substituted or unsubstituted phenyl and substituted or unsubstituted phenoxy (preferably selected from the group consisting of hydrogen, methyl, and t-butyl; more preferably hydrogen).

Aryl is phenyl or phenyl substituted with one or more of groups selected from the group consisting of methyl, ethyl, linear or branched C₃₋₆ alkyl, hydroxy, methoxy, ethoxy, linear or branched C₃₋₆ alkyloxy, acetoxy, C₂₋₆ acyl, hydroxymethyl, hydroxyethyl, linear or branched hydroxy C₃₋₆ alkyl, phenyl and phenoxy; preferably phenyl.

Optionally one of R₁ or R₂ taken together with one of R₃ or R₄ and the carbon atoms to which they are attached to form a C₅₋₇ carbocyclic ring optionally containing one or more double bonds. It is also one good embodiment that none of R₁ or R₂ taken together with any of R₃ or R₄ to form a C₅₋₇ carbocyclic ring.

As one embodiment of this invention, formula (I) can be formula (I-a). 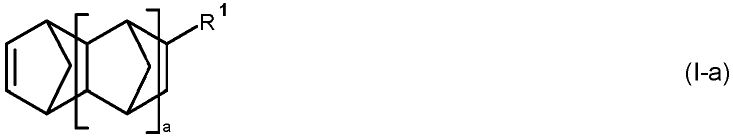
a is 0 or 1. As one of the embodiments, a is 0. As another embodiment, a is 1.
R¹ is a linear or branched C₁₋₂₀ alkyl group or an unsubstituted C₆₋₁₀ aryl C₁₋₆ alkyl (preferably methyl, ethyl, isopropyl, t-butyl, n-butyl, n-hexyl, n-octyl phenylmethyl or phenethyl; more preferably n-butyl, n-hexyl, n-octyl or phenethyl).

As preferred embodiments, formula (I) can be selected from the group consisting of the following formula (I-a-01) to (I-a-21):

| | | |
|---|---|---|
| 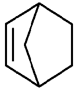 | NB | (I-a-01) |
| 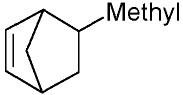 | MeNB | (I-a-02) |
| 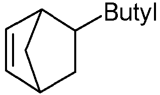 | BuNB | (I-a-03) |
| 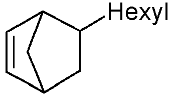 | HexNB | (I-a-04) |
| 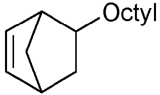 | OctNB | (I-a-05) |
| 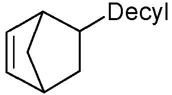 | DecNB | (I-a-06) |
| 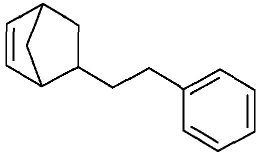 | PENB | (I-a-07) |
| 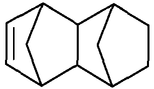 | TD | (I-a-08) |
| 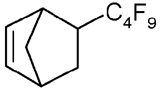 | NBC₄F₉ | (I-a-09) |
| 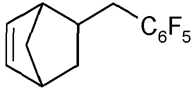 | NBCH₂C₆F₅ | (I-a-10) |
| 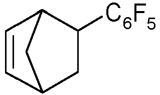 | NBC₆F₅ | (I-a-11) |
| 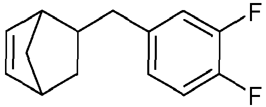 | NBCH₂C₆H₃F₂ | (I-a-12) |
| 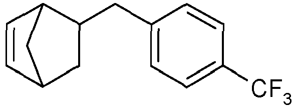 | NBCH₂C₆H₄C F₃ | (I-a-13) |
| 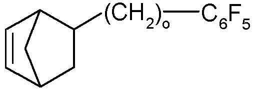 | NBalkylC₆F₅ | (I-a-14) |
| 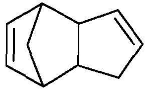 | DCPD | (I-a-15) |
| 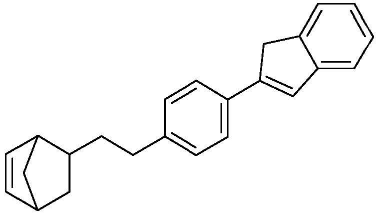 | EtPhIndNB | (I-a-16) |
| 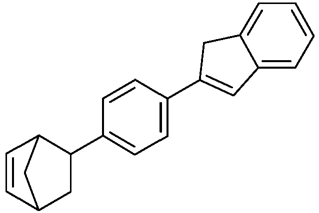 | PhIndNB | (I-a-17) |
| 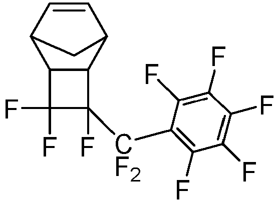 | PFBTCNB | (I-a-18) |
| | PMNB | (I-a-19) |
| 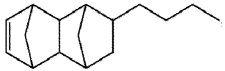 | ButylTD | (I-a-20) |
| 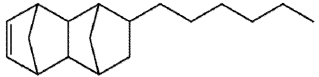 | HexylTD | (I-a-21) |
| 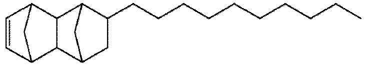 | OctylTD | (I-a-22) |

As more preferred embodiments, formula (I) can be selected from the group consisting of the above formula (I-a-04), (I-a-05), (I-a-07), (I-a-08), (I-a-19), (I-a-20), (I-a-21) and (I-a-22). As further preferred embodiments, formula (I) can be selected from the group consisting of the above formula (I-a-04), (I-a-07), (I-a-08), (I-a-20), and (I-a-21).

As one embodiment of the composition of this invention, the content of the (a) monomer is 80-99.99 mass% (preferably 90-99.99 mass%; more preferably 90-99.95 mass%) based on the composition.

As (a) monomer, mixture of isomers each represented by formula (I) is accepted in this invention.

### [(b) metal catalyst]

The composition of the invention comprises (b) a latent organo-transition metal catalyst comprising a metal selected from the group consisting of ruthenium, osmium, or palladium. The metal is preferably ruthenium or osmium (more preferably ruthenium).

The latent organo-transition metal catalyst can be an organo-ruthenium compound selected from the group consisting of a compound of formula (IIA), a compound of formula (IIB), a compound of formula (IIIA), a compound of formula (IIIB), a compound of formula (IIIC), and a compound of formula (IIID).

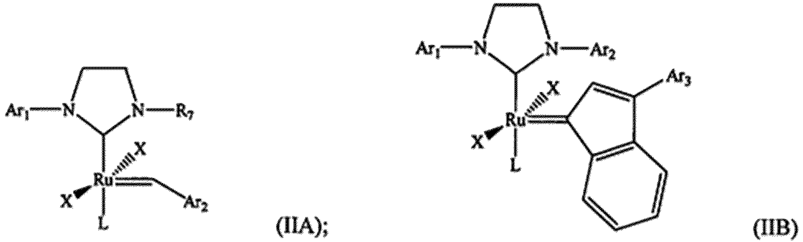

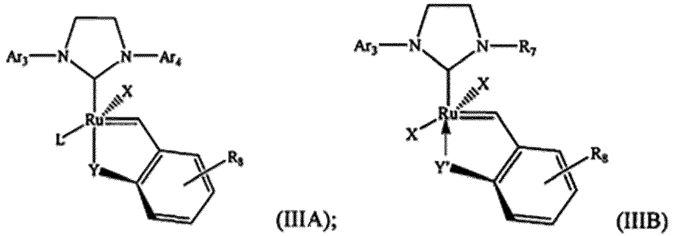

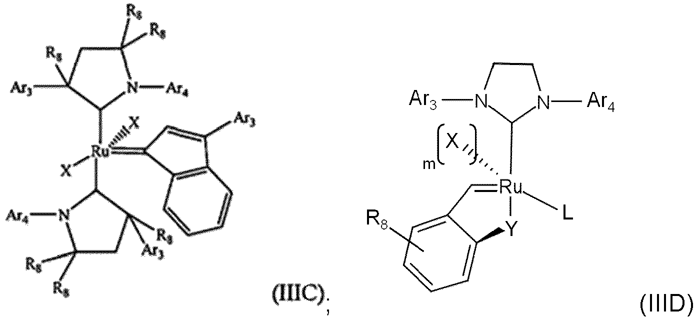

As preferable embodiment of this invention, the organo-ruthenium compound is selected from the group consisting of a compound of formula (IIB), a compound of formula (IIIA), a compound of formula (IIIB), and a compound of formula (IIID). As more preferable embodiment of this invention, the organo-ruthenium compound is a compound of formula (IIIA), or a compound of formula (IIID).

The metal of ruthenium of formula (IIA), formula (IIB), formula (IIIA), formula (IIIB), formula (IIIC), or formula (IIID) can be optionally replaced by osmium or palladium. It is further preferable embodiment of the invention that the metal of (b) metal catalyst is ruthenium.

X is each independently selected from the group consisting of chlorine, bromine, iodine, -ORₐ, -O(CO)Rₐ, -S(Rₐ)₂, -OSO₂Rₐ and -N(Rₐ)₂. As one preferable embodiment, X is each independently selected from the group consisting of chlorine, bromine, iodine, -S(Rₐ)₂, -OSO₂Rₐ, and -N(Rₐ)₂. As one more preferable embodiment, X is each independently selected from the group consisting of iodine, -S(Rₐ)₂, and -N(Rₐ)₂.

Rₐ is each independently selected from the group consisting of single bond, C₁₋₁₂ alkyl, C₃₋₁₂ cycloalkyl, C₆₋₁₄ aryl and =CH(Rₐ'). As one preferable embodiment, Rₐ is each independently selected from the group consisting of single bond, C₁₋₄ alkyl, phenyl, and =CH(Rₐ'). As one more preferable embodiment, Rₐ is each independently selected from the group consisting of single bond, phenyl, and =CH(Rₐ').

Any combination of two combination Rₐs can bond each other.

Rₐ' is a single bond which binds to Rₐ or L (preferably to L).

Y is selected from the group consisting of O, S and NCOCF₃ (preferably O and S; more preferably O).

Y' is selected from the group consisting of OR₉, SR₉ and - N=CHC(O)O(C₁₋₆ alkyl).

R₉ is selected from the group consisting of methyl, ethyl, linear or branched C₁₋₆ alkyl, C₆₋₁₀ aryl, methoxy, ethoxy, linear or branched C₁₋₆ alkoxy, C₆₋₁₀ aryloxy and -OCH(CH₃)C(O)N(CH₃)(OCH₃). Preferable embodiment of R₉ is selected from the group consisting of methyl, ethyl, linear or branched C₃₋₆ alkyl, C₆₋₁₀ aryl, methoxy, ethoxy, linear or branched C₃₋₆ alkoxy, C₆₋₁₀ aryloxy and -OCH(CH₃)C(O)N(CH₃)(OCH₃).

L is selected from the group consisting of pyridine, PR₃, 0=PR₃ and -OR₃ (preferably PR₃ and -O-R₃).

R₃ is independently selected from the group consisting of isopropyl, sec-butyl, tert-butyl, cyclohexyl, bicyclo C₅₋₁₀ alkyl, phenyl, benzyl, isopropoxy, sec-butoxy, tert-butoxy, cyclohexyloxy, phenoxy and benzyloxy (preferably isopropyl, sec-butyl, tert-butyl, cyclohexyl, bicyclo C₅₋₁₀ alkyl, phenyl, benzyl, isopropoxy, sec-butoxy, tert-butoxy, cyclohexyloxy, phenoxy and benzyloxy; more preferably cyclohexyl, and phenyl).

Any one of X and L can form an anionic ligand of the formula X-L.

R₇ is selected from the group consisting of isopropyl, sec-butyl, tert-butyl, substituted or unsubstituted cyclohexyl, substituted or unsubstituted phenyl, substituted or unsubstituted biphenyl and substituted or unsubstituted naphthyl (preferably isopropyl, sec-butyl, tert-butyl, cyclohexyl, substituted phenyl, and substituted naphthyl; more preferably cyclohexyl, and substituted phenyl, and substituted naphthyl).

R₈ is selected from the group consisting of hydrogen, chlorine, methyl, ethyl, linear or branched C₁₋₆ alkyl, C₆₋₁₀ aryl, methoxy, ethoxy, linear or branched C₁₋₆ alkoxy, C₆₋₁₀ aryloxy, -NHCO(C₁₋₆)alkyl, -NHCO-perfluoro(C₁₋₆)alkyl, -SO₂N((C₁₋₆)alkyl)₂ and -NO₂. It is one preferred embodiment of this invention that R₈ is selected from the group consisting of hydrogen, chlorine, methyl, ethyl, phenyl, methoxy, ethoxy, and -NO₂. More preferably R₈ is hydrogen.

Ar₁, Ar₂ Ar₃ and Ar₄ are each independently selected from the group consisting of substituted or unsubstituted phenyl, substituted or unsubstituted biphenyl and substituted or unsubstituted naphthyl (preferably substituted or unsubstituted phenyl; more preferably substituted phenyl). As one embodiment of this invention, each Ar₁, Ar₂ Ar₃ and Ar₄ independently preferably has 1-3 substituent (s) on the selected group (more preferably 1 or 3 substituents; further preferably 3 substituents; alternatively further preferably 1 substituent).

When above described groups have substituent(s), substituents are each independently selected from the group consisting of methyl, ethyl, iso-propyl, tert-butyl, phenyl and OSi(SiMe₃)₃ (preferably methyl, ethyl, and iso-propyl; more preferably methyl, and iso-propyl). In here, "Me" of "OSi(SiMe₃)₃" is methyl.

m is an integer of 1, 2 or 3 (preferably 1 or 2; more preferably 1). It is also one another more preferable embodiment of this invention that m is 2.

Though there's no intent to limit the scope of this invention, exemplified compounds of the (b) latent organo-transition metal catalyst can be described as below.

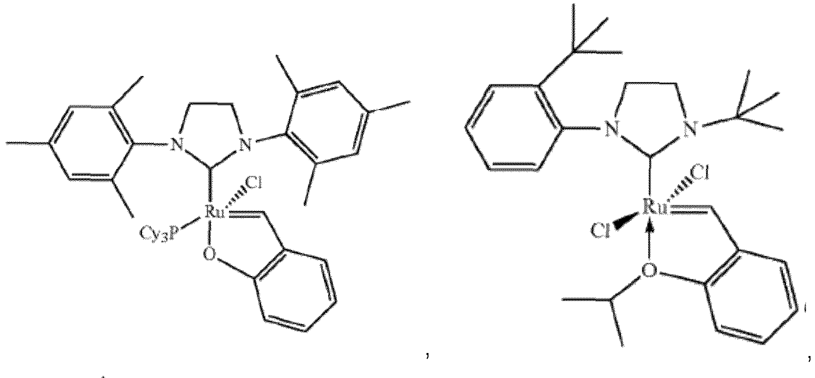

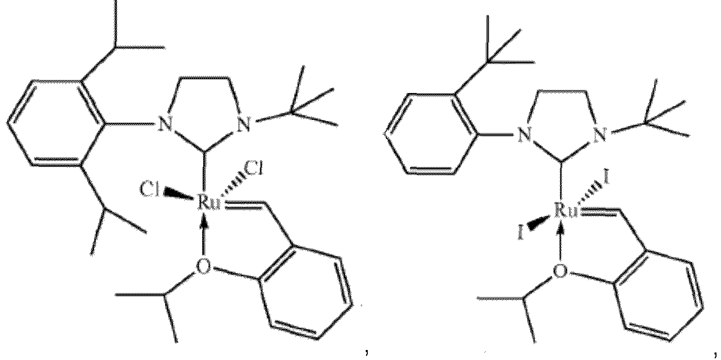

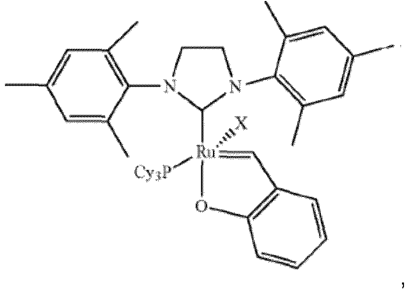

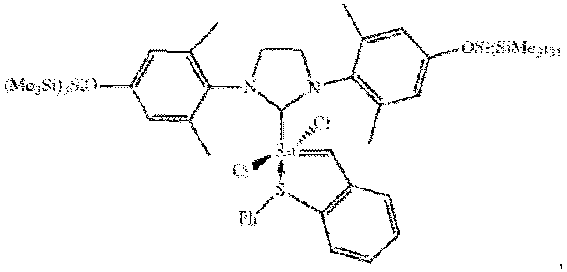

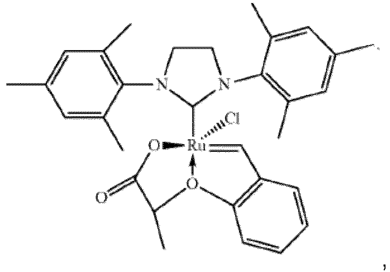

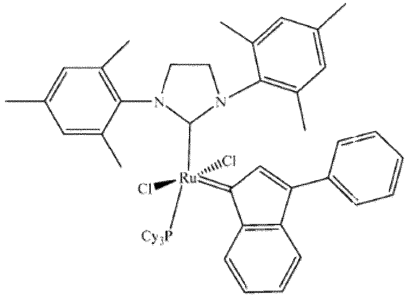

The content of the (b) latent organo-transition metal catalyst is 0.0001-1.0 mass % (preferably 0.001-0.5 mass %; more preferably 0.005-0.4 mass %; further preferably 0.010-0.10 mass %) based on the composition.

### [(c) compound capable of releasing a Bronsted acid]

The composition of this invention comprises (c) a compound capable of releasing a Bronsted acid when subjected to photolytic conditions.

The (c) compound is represented by the below formula (V).

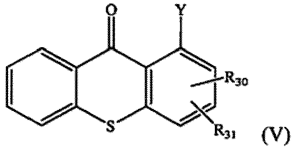

Y is halogen (preferably chlorine, bromine, or iodine; more preferably chlorine).

R₃₀ and R₃₁ are each independently selected from the group consisting of hydrogen, methyl, ethyl, linear or branched C₃₋₁₂ alkyl, C₃₋₁₂ cycloalkyl, C₆₋₁₂ bicycloalkyl, C₇₋₁₄ tricycloalkyl, C₆₋₁₀ aryl, C₆₋₁₀ aryl C₁₋₃ alkyl, C₁₋₁₂ alkoxy, C₃₋₁₂ cycloalkoxy, C₆₋₁₂ bicycloalkoxy, C₇₋₁₄ tricycloalkoxy, C₆₋₁₀ aryloxy C₁₋₃ alkyl and C₆₋₁₀ aryloxy.

R₃₀ is preferably selected from the group consisting of hydrogen methyl, ethyl, iso-propyl, n-propyl, phenyl, methoxy, ethoxy, iso-propoxy, n-propoxy, and phenoxy (more preferably hydrogen methyl, ethyl and t-butyl; further preferably hydrogen, and t-butyl; further more preferably hydrogen).

R₃₁ is preferably selected from the group consisting of methyl, ethyl, iso-propyl, n-propyl, phenyl, methoxy, ethoxy, iso-propoxy, n-propoxy, and phenoxy (more preferably methyl, ethyl, n-propyl, methoxy, ethoxy, n-propoxy, and phenoxy; further preferably ethoxy, and n-propoxy; further more preferably n-propoxy).

Though there's no intent to limit the scope of this invention, exemplified compounds of the (c) compound capable of releasing a Bronsted acid when subjected to photolytic conditions can be described as below.

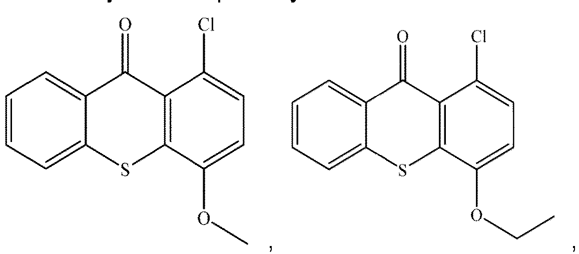

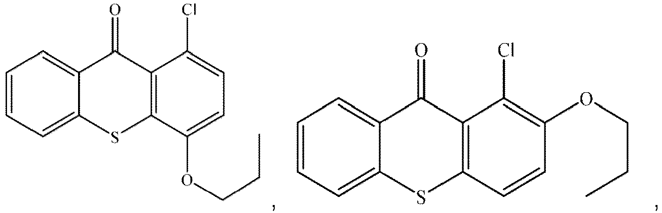

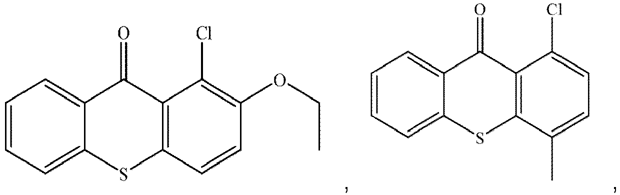

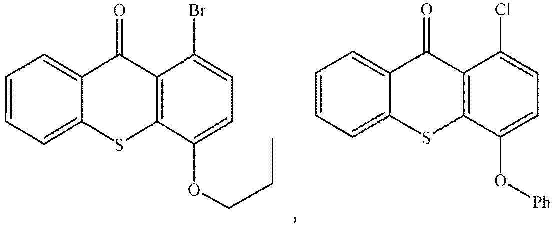

The content of the (c) compound capable of releasing a Bronsted acid is 0.0001-1.0 mass % (preferably 0.001-0.5mass%; more preferably 0.01-0.40 mass%; further preferably 0.02-0.10 mass%) based on the composition.

### [(d) absorber compound]

The composition of this invention comprises (d) an absorber compound having a maximum absorption at a wavelength between 280-410 nm. It is one embodiment of this invention that the (d) absorber compound has a maximum absorption wavelength preferably between 300-410 nm (more preferably 350-410 nm).

Light absorption characteristic can be measured by known method. For example, the (d) absorber compound is dissolved in a non-polar organic solvent (e.g., 1-Heptyl-2-norbornene), and the solution is evaluated regarding each light source (e.g., UV) absorption spectrum using known spectroscopy equipment.

The (d) absorber compound works to block UV by a mechanism of "Exited state intramolecular proton transfer (ESIPT)"; and/or the (d) absorber compound is excited by electronic field when formed (preferably by deposition) to the layer.

It is one preferable embodiment of this invention that the (d) absorbers compound works to block UV by a mechanism of ESIPT.

The (d) absorber compound can have hydroxyl and/or methoxy (preferably hydroxyl or methoxy; more preferably hydroxyl).

The (d) absorber compound is represented by a formula selected from the group consisting of the following formula (d-1), (d-2) and (d-3) (more preferably (d-1), and (d-2); further preferably (d-1)). Such (d) absorber compound is preferable to work ESIPT mechanism in the layer formed by the composition of this invention. Each formula is described in detailed below.

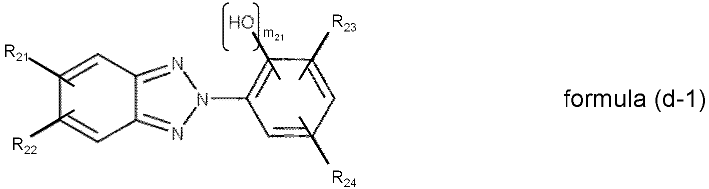

R₂₁ and R₂₂ are each independently hydrogen, linear or branched C₁₋₅ alkyl or C₆₋₁₀ aryl (preferably hydrogen, or linear C₁₋₅ alkyl).

Optionally C₁₋₅ alkyls of R₂₁ and R₂₂ can bond each other to make a saturated or unsaturated ring. As one embodiment of this invention, C₁₋₅ alkyls of R₂₁ and R₂₂ preferably bond each other to make a saturated ring (more preferably to make a cyclopentane). Optionally one or more of methylene of such saturated ring can be each independently replaced with -(C=O)- or -NR₂₅-. As one embodiment of this invention, preferably two or three of methylene of such saturated ring each independently replaced with -(C=O)- or -NR₂₅-.

Formula (d-1) can be formula (d-1-1) described below. When read (d-1-1) from formula (d-1), C₁₋₅ alkyls of R₂₁ and R₂₂ bond each other to make a saturated ring (cyclopentane). 2 methylenes in the cyclopentane are replaced with -(C=O)- linkers. 1 methylene in the cyclopentane is replaced with -NR₂₅-.

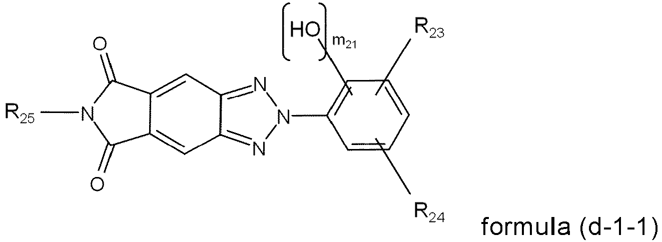

R₂₅ is each dependently hydrogen, linear or branched C₁₋₅ alkyl or C₆₋₁₀ aryl (preferably hydrogen, methyl, ethyl, iso-propyl, n-propyl, n-butyl, t-butyl, or phenyl; more preferably hydrogen, methyl, n-propyl, n-butyl, or phenyl; further preferably n-butyl).

m₂₁ is an integer of 1-3 (preferably 1 or 2; more preferably 1).

R₂₃ and R₂₄ are each independently C₁₋₁₀ alkyl, C₆₋₁₈ aryl, C₆₋₁₂ aryl C₁₋₅ alkyl, or C₁₋₅ alkyl C₆₋₁₂ aryl (preferably C₄₋₈ alkyl, phenyl, and phenyl C₁₋₃ alkyl; more preferably C₅₋₈ alkyl, and phenyl C₁₋₃ alkyl).

Alkyl portion of R₂₃ and R₂₄ can be linear or branched each independently (preferably whole or part of such alkyl portion is branched).

Optionally methylene of alkyl portion of R₂₃ and R₂₄ can be replaced with - CO-, -O-, or -COO- (preferably -COO-).

Though there's no intent to limit the scope of this invention, exemplified compounds of formula (d-1) can be described as below.

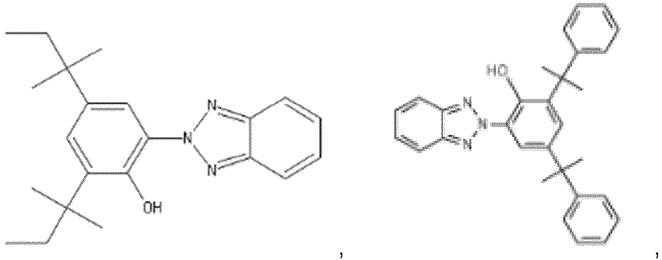

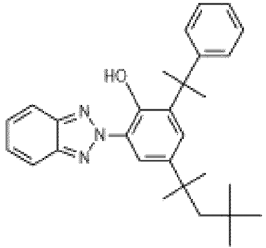

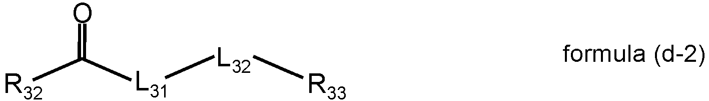

R₃₂ and R₃₃ are each independently C₁₋₂₁ hydrocarbon groups (preferably linear or branched C₁₋₂₁ alkyl; more preferably linear or branched C₁₋₁₀ alkyl). C₁₋₂₀ hydrocarbon groups of R₃₂ and R₃₃ can optionally form saturated or unsaturated ring (preferably benzene ring). The compound represented by formula (d-2) can have one or more portion of carbon-carbon single bond replaced with carbon-carbon double bond. Preferably R₃₂ and R₃₃ can have one or more portion of carbon-carbon single bond replaced with carbon-carbon double bond. Methylene portion of the R₃₂ can be replaced with -O- or -CO-.

L₃₁ is a C₁₋₁₂ hydrocarbon linker (preferably linear or branched C₁₋₆ alkylene; more preferably linear or branched C₁₋₄ alkylene; further preferably methylene). L₃₁ can optionally form saturated or unsaturated ring (preferably phenylene). Methylene portion of the L₃₁ optionally can be replaced with -O-. L₃₂ is -CO-, -CH₂-, or -CH(CH₃)- (preferably -CO-, or -CH(CH₃)-; more preferably -CH(CH₃)-).

At least one of methyl in the compound represented by formula (d-2) is replaced by hydroxyl or methoxy.

Though there's no intent to limit the scope of this invention, exemplified compounds of formula (d-2) can be described as below.

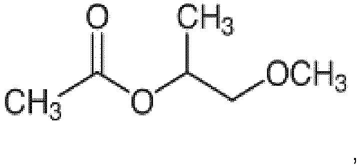

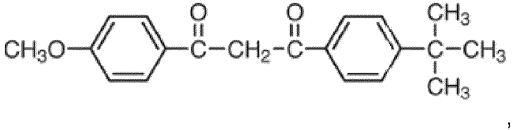

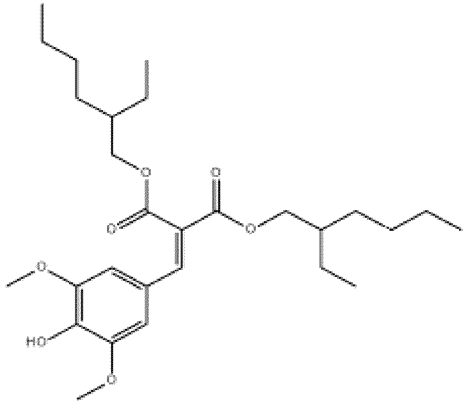

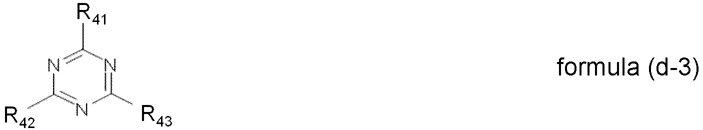

R₄₁, R₄₂ and R₄₃ are each independently C₁₋₂₀ hydrocarbon groups. C₁₋₂₀ hydrocarbon groups of R₄₁, R₄₂ or R₄₃ can optionally form saturated or unsaturated ring (preferably benzene ring). Methylene portion of the R₄₁, R₄₂ or R₄₃ can optionally be replaced with -O-.

At least one of methyl in the compound represented by formula (d-3) is replaced by hydroxyl or methoxy.

Though there's no intent to limit the scope of this invention, exemplified compound of formula (d-3) can be described as below.

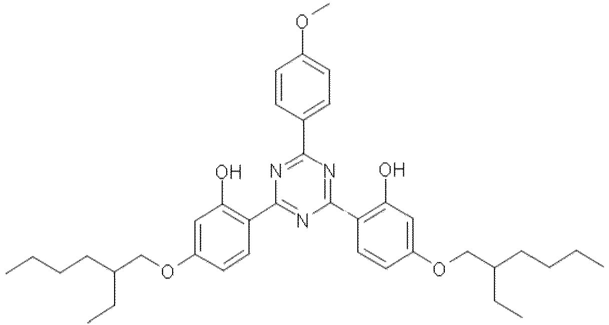

(d) absorber compounds can be obtained by market. Examples of commercially available (d) absorbers can be selected from the group consisting of Tinuvin328, Tinuvin477, Tinuvin900, Tinuvin928, Tinuvin970, Tinuvin384, Eusolex 9020, Oxynex ST, Eusolex S, BL1226, BL1337 (Jade New Material), FDB-009 (Yamada Chemical), LOTSORB B series (Jiangxi Lotchem), LA-F70 (Adeka Fine Chemicals) and any combination of any of them.

As another embodiment of this disclosure, (d) absorber compound can have a character to be excited by electronic field when formed to the layer. For example, chemical compounds used in OLED have such character. Such (d) absorber compounds can be used in emission layer (EML, as host or dopant), hole transporting layer (HTL), hole injection layer (HIL), electron transporting layer (ETL), or electron injection layer (EIL) in OLED. Herein later, such (d) absorber compounds which can exhibit property(s) for OLED are denoted as "(d) absorber compound with OLED property". Such (d) absorber compounds can be used in HTL or HIL in OLED. Such (d) absorber compounds can also be used in HTL in OLED.

Such layer formation can be done by coating or deposition (preferably vacuumed deposition).

The examples of (d) absorber compounds with OLED property can hole-injection and/or hole-transport properties when formed in layer in OLED. Those include, for example, triarylamines, benzidines, tetraaryl-para-phenylenediamines, triarylphosphines, phenothiazines, phenoxazines, dihydrophenazines, thianthrenes, dibenzo-para-dioxins, phenoxathiynes, carbazoles, azulenes, thiophenes, pyrroles and furans as well as their derivatives and further O-, S- or N-containing heterocycles having a high HOMO (HOMO = highest occupied molecular orbital).

As compounds which have hole-injection and/or hole-transport properties, particular mention may be made of phenylenediamine derivatives (US 3615404), arylamine derivatives (US 3567450), amino-substituted chalcone derivatives (US 3526501), styrylanthracene derivatives (JP-A-56-46234), polycyclic aromatic compounds (EP 1009041), polyarylalkane derivatives (US 3615402), fluorenone derivatives (JP-A-54-110837), hydrazone derivatives (US 3717462), acylhydrazones, stilbene derivatives (JP-A-61-210363), silazane derivatives (US 4950950), polysilanes (JP-A-2-204996), aniline copolymers (JP-A-2-282263), thiophene oligomers (JP Heisei 1 (1989) 211399), polythiophenes, poly(N-vinylcarbazole) (PVK), polypyrroles, polyanilines and other electrically conducting macromolecules, porphyrin compounds (JP-A-63-2956965, US 4720432), aromatic dimethylidene-type compounds, carbazole compounds, such as, for example, CDBP, CBP, mCP, aromatic tertiary amine and styrylamine compounds (US 4127412), such as, for example, triphenylamines of the benzidine type, triphenylamines of the styrylamine type and triphenylamines of the diamine type. It is also possible to use arylamine dendrimers (JP Heisei 8 (1996) 193191), monomeric triarylamines (US 3180730), triarylamines containing one or more vinyl radicals and/or at least one functional group containing active hydrogen (US 3567450 and US 3658520), or tetraaryldiamines (the two tertiary amine units are connected via an aryl group). More triarylamino groups may also be present in the molecule. Phthalocyanine derivatives, naphthalocyanine derivatives, butadiene derivatives and quinoline derivatives, such as, for example, dipyrazino[2,3-f:2',3'-h]quinoxalinehexacarbonitrile, are also suitable.

According to the present invention, aromatic tertiary amines containing at least two tertiary amine units (US 2008/0102311 A1, US 4720432 and US 5061569), such as, for example, NPD (α-NPD = 4,4'-bis[N-(1-naphthyl)-N-phenylamino]biphenyl) (US 5061569), TPD 232 (= N,N'-bis-(N,N'-diphenyl-4-aminophenyl)-N,N-diphenyl-4,4'-diamino-1,1'-biphenyl) or MTDATA (MTDATA or m-MTDATA = 4,4',4"-tris[3-methylphenyl)phenylamino]-triphenylamine) (JP-A-4-308688), TBDB (= N,N,N',N'-tetra(4-biphenyl)-diaminobiphenylene), TAPC (= 1,1-bis(4-di-p-tolylaminophenyl)cyclohexane), TAPPP (= 1,1-bis(4-di-*p*-tolylaminophenyl)-3-phenylpropane), BDTAPVB (= 1,4-bis[2-[4-[N,N-di(p-tolyl)amino]phenyl]vinyl]benzene), TTB (= N,N,N',N'-tetra-*p*-tolyl-4,4'-diaminobiphenyl), TPD (= 4,4'-bis[N-3-methylphenyl]-N-phenylamino)biphenyl), N,N,N',N'-tetraphenyl-4,4‴-diamino-1,1',4',1'',4'',1‴-quaterphenyl, likewise tertiary amines containing carbazole units, such as, for example, TCTA (= 4-(9H-carbazol-9-yl)-N,N-bis[4-(9H-carbazol-9-yl)phenyl]-benzenamine) can be used as (d) absorber compound. Preference is likewise given to hexaazatriphenylene compounds in accordance with US 2007/0092755 A1 and phthalocyanine derivatives (for example H₂Pc, CuPc (= copper phthalocyanine), CoPc, NiPc, ZnPc, PdPc, FePc, MnPc, ClAlPc, ClGaPc, CllnPc, ClSnPc, Cl₂SiPc, (HO)AlPc, (HO)GaPc, VOPc, TiOPc, MoOPc, GaPc-O-GaPc).

Examples of (d) absorber compounds with OLED property can be described as below formulae (TA-1) to (TA-16), which are disclosed in EP 1162193 B1, EP 650 955 B1, Synth. Metals 1997, 91(1-3), 209, DE 19646119 A1, WO 2006/122630 A1, EP 1 860 097 A1, EP 1834945 A1, JP 08053397 A, US 6251531 B1, US 2005/0221124, JP 08292586 A, US 7399537 B2, US 2006/0061265 A1, EP 1 661 888 and WO 2009/041635. The said compounds of the formulae (TA-1) to (TA-16) may also be substituted.

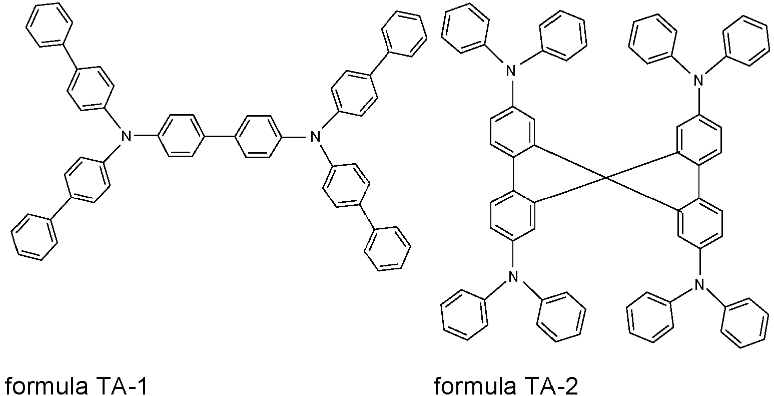

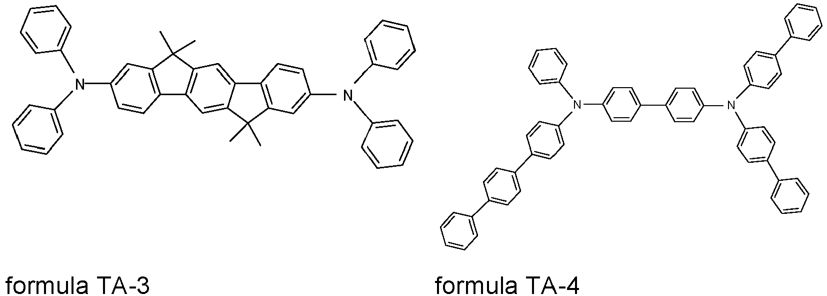

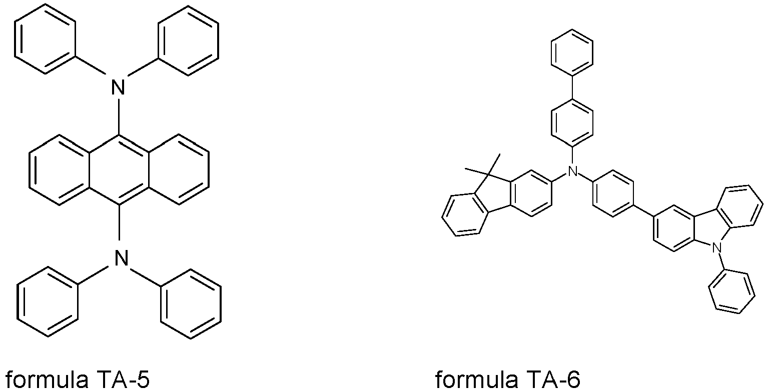

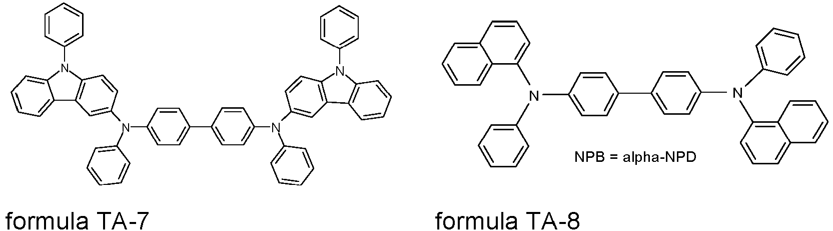

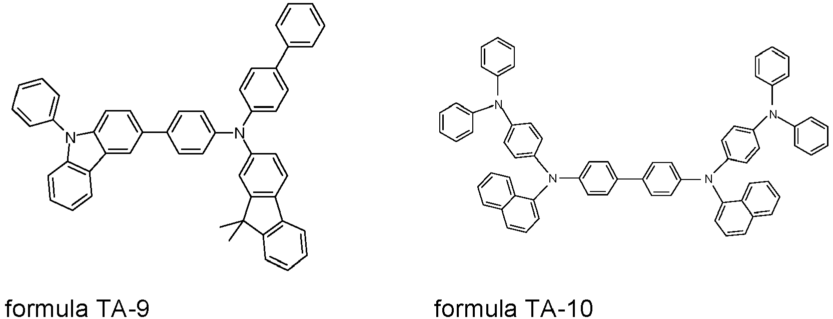

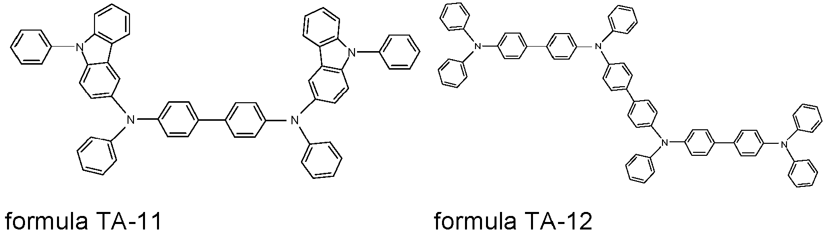

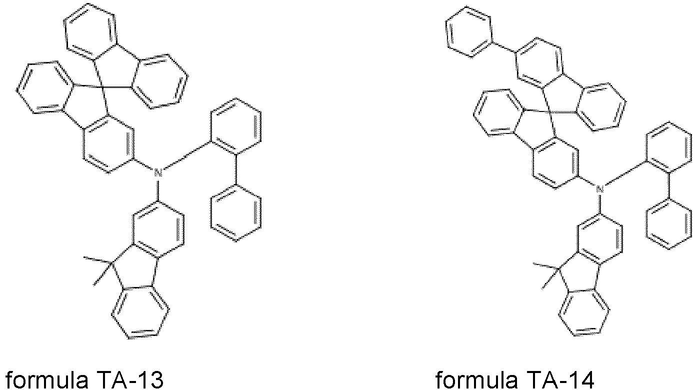

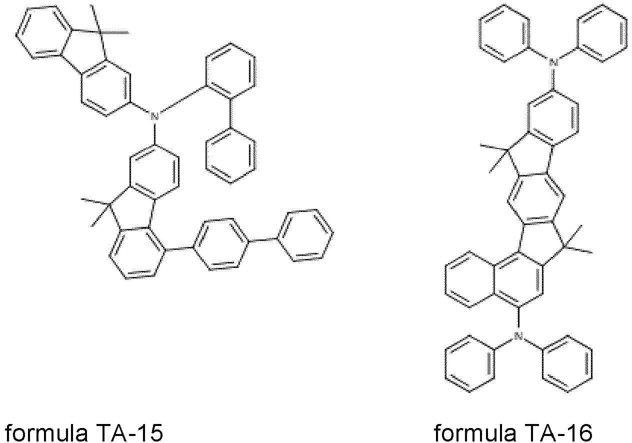

Further compounds with OLED property are described in EP 0891121 A1,EP 1029909 A1, and US 2004/0174116 A1.

These arylamines and heterocycles preferably result in a HOMO in the layer formed by them of greater than -5.8 eV (vs. vacuum level) (more preferably greater than -5.5 eV).

As one embodiment of the composition of this invention, the content of the (d) absorber compound is 0.5-15 mass% (preferably 1-15 mass%; more preferably 2-10 mass%; further preferably 2-6 mass %) based on the composition. For clarity, when the composition comprises plural species of (d) absorber compounds, the said contents is the sum of these (d) absorber compounds.

### [Additive]

The composition of this invention can further comprise additive. Here, additive is different from the components described above. The additive can be selected from the group consisting of anti-oxidant, synergist, viscosity modifier, binder, solvent, other absorber and any combination of any of these. In here, other absorber means compound absorb light which is different from whichever compound represented by formula (d-1), (d-2) and (d-3), and whichever compound which can be excited by electronic field when formed to the layer. As the solvent, for example organic solvent is useful to dissolve certain compound whose solubility is low. Embodiments described in US2020/002466 A1 or WO2020/002277A1 can be generally employed as such additive.

As one embodiment of the composition of this invention, the content of such additive is 0-15 mass% (preferably 0.01-10 mass%; more preferably 0.1-5 mass%; further preferably 0.1-1 mass %) based on the composition. It is another preferable embodiment that the composition of this invention does not comprise such additive (0.0 mass %) based on the composition.

As one embodiment, the composition of this invention can further comprise a solvent. The solvent is preferably inorganic solvent or organic solvent (more preferably organic solvent). The content of such solvent is preferably 0.0 - 1.0 mass % (more preferably 0.001 -0.5 mass%; further preferably 0.001 - 0.1 mass%; further more preferably 0.001-0.01 mass%) based on the composition. It is another preferable embodiment that the composition of this invention does not comprise such solvent (0.000 mass %) based on the composition.

### [Layer forming]

This invention provides a method of manufacturing a polycycloolefin layer comprising below steps.
(1) preparing a base member;
(2) applying the composition of this invention above the base member; and
(3) polymerizing the (a) monomers in the composition.

The numbers in parentheses indicate the order of the steps. For example, when the steps (1), (2) and (3) are described, the order of the steps is as described above. Same to hereinafter, unless specifically described.

Here, in the present invention, the "above" includes the case where a polycycloolefin layer is formed on (direct contact with) a base member and the case where a polycycloolefin layer is formed above a base member via another layer. For example, a planarization film can be formed on a base member, and the composition of this invention can be applied on the planarization film.

In general terms the present application also relates to an electronic device, preferably an organic electronic device, comprising a base member, and a polycycloolefin layer, which may be produced in accordance with the present method as described herein.

Said base member is not particularly limited and may, in principle, be any member (for example, a substrate or a device or device component, all of which are described in the following) whereupon a polycycloolefin layer may be deposited. Without wishing to be bound by theory, this polycycloolefin layer is believed to contribute to protecting the underlying base member from water, oxygen, dust, or any other materials harmful to the underlying base member.

The base member is preferably an electronic device or a component of an electronic device, and more preferably an organic electronic device or a component of an organic electronic devices.

Examples of such base members may be selected from the group of electronic devices consisting of light emitting diodes, photovoltaic cells, photodetector cells, semiconductor devices, and thin film transistors, all of which may be organic, inorganic or hybrid.

Generally, such electronic device comprises, preferably in sequence, a first electrode, a functional layer, and a second electrode. The functional layer may, for example, be selected from the group consisting of light emitting layer, semiconductor layer, and photoactive layer.

Depending upon the architecture of the resulting electronic device, the polycycloolefin layer may be on the side of (but not necessarily directly adhered thereto) the first electrode or the second electrode.

The substrate, whether as part of a base member or in itself constituting the base member, is not particularly limited. Suitable substrates are preferably inert under use conditions. Such substrates may, for example, be flexible. Preferred examples of suitable substrate materials may be selected from polymers, glass, metals and any blend of any of these, including for example blends of more than one polymer or metal. Preferred polymeric materials include but are not limited to alkyd resins, allyl esters, benzocyclobutenes, butadiene-styrene, cellulose, cellulose acetate, epoxide, epoxy polymers, ethylene-chlorotrifluoro ethylene copolymers, ethylene-tetra-fluoroethylene copolymers, fiber glass enhanced polymers, fluorocarbon polymers, hexafluoropropylenevinylidene-fluoride copolymer, high density polyethylene, parylene, polyamide, polyimide, polyaramid, polysiloxanes (e.g. polydimethylsiloxane), polyethersulphone, polyethylene, polyethylenenaphthalate, polyethyleneterephthalate, polyketone, polymethylmethacrylate, polypropylene, polystyrene, polysulphone, polytetrafluoroethylene, polyurethanes, polyvinylchloride, polycycloolefin, silicone rubbers, silicones, and maleimide-type resins. Of these polyethyleneterephthalate, polyimide, polycycloolefin and polyethylenenaphthalate materials are more preferred. Additionally, for some embodiments of the present invention the substrate can be any suitable material, for example a polymeric material, metal or glass material coated with one or more of the above listed materials or coated with one or more metal, such as for example titanium. It will be understood that in forming such a substrate, methods such as extruding, stretching, rubbing or photochemical techniques can be employed to provide a homogeneous surface for device fabrication. Alternatively, the substrate can be a polymeric material, metal or glass coated with one or more of the above polymeric materials.

In the step (2) of this invention, the measure of "applying" the composition is preferably selected from the group consisting of deposition, dip coating, spin coating, ink jet printing, nozzle printing, letter-press printing, screen printing, gravure printing, doctor blade coating, roller printing, reverse-roller printing, offset lithography printing, dry offset lithography printing, flexographic printing, web printing, spray coating, curtain coating, brush coating, slot dye coating and pad printing (more preferably deposition, spin coating, ink jet printing or nozzle printing; further preferably spin coating, and ink jet printing; further more preferably ink jet printing).

In the step (3) of this invention, the (a) monomers are polymerized to be a polycycloolefin layer. The measure of "polymerizing" in the step (3) is performed by irradiation and/or heat (preferably irradiation). As above irradiation, wavelength having 260-430 nm peak top wavelength can be preferably used (more preferably 350-410 nm peak top; further preferably 380-400 nm peak top). UV irradiation is one preferable embodiment of such irradiation. The atmosphere of such irradiation can be selected from the known conditions such like that air atmosphere, nitrogen, and mixture of them. Temperature can be controlled as know conditions such like that 20-27 °C (preferably 25-27 °C).

As mentioned above, heat treatment by applying increased temperature to the composition above the base member is one embodiment of this invention. 50-150 °C (preferably 70-120 °C) is one embodiment of such condition. 10-180 minutes (preferably 10-60 minutes) is one embodiment of such condition. The atmosphere of such heat treatment can be selected from the known conditions such like that air atmosphere, nitrogen, and mixture of them. Temperature can be controlled as know conditions such like that 20-27 °C (preferably 25-27 °C).

By using the composition of this invention, it's possible to form a substantially transparent layer when exposed to suitable radiation. The polycycloolefin polymer manufactured by methods described in this specification can be the substantially transparent layer. The suitable radiation source can be a natural light, or artificial light (e.g., LED light). The substantially transparent layer can have an average transmission of preferably 80-99.9% (more preferably 90-99.9%; further preferably 95-99.9%; further more preferably 97-99.9%) of the 450-800 nm wavelength light.

It is preferable embodiment of this invention that is most of the visible light is transmitted through the layer. Accordingly, as one embodiment of this invention, such layer can have preferably 90-100% (more preferably 90-99.9%; further preferably 95-99.9%) of visible light) of visible light transmission. The visible light can be preferably 360-830 nm (more preferably 400-830 nm; further preferably 400-760 nm).

The substantially transparent layer can have an average transmission of 5-60% as of the range of 250-450 nm wavelength light. Without wishing to be bounded by theory, by including (d) absorber compound in the composition of this invention, the composition can avoid chemical process obstacles (e.g., turbidity, unsolved residue), and/or the substantially transparent layer can transmit most of visible light with reducing certain range of light. Without wishing to be bounded by theory, the substantially transparent layer can be incorporated in the light emitting device which can exhibit good visibility.

It is preferable embodiment of this invention that the substantially transparent layer has an average transmission of 5-25% as of the range of 310-360 nm wavelength light. It is preferable embodiment of this invention that the substantially transparent layer has an average transmission of 1-20% as of the range of 370-410 nm wavelength light. Transmission amount can be measured and evaluated by known methods.

It is one embodiment of this invention that the manufactured polycycloolefin layer can have a permittivity of preferably 3 or less (more preferably 2.6 or less; further preferably 2.5 or less). A permittivity of the polycycloolefin layer can be evaluated by known methods. Without wishing to be bound by theory, the polycycloolefin layer having above permittivity can exhibit characters as encapsulation layer or insulation layer.

As one embodiment of this invention, the polymer of polycycloolefin of this invention is formed having a weight average molecular weight (M_{w}) from 5,000 to 500,000 (more preferably 10,000 to 400,000; further preferably 20,000 to 250,000). In the present invention, Mw and Mn can be measured by the gel permeation chromatography (GPC). In this measurement, it is a preferable example to use a GPC column at 40°C, an eluent tetrahydrofuran at 0.6 mL/min and mono-dispersed polystyrene as a standard.

This invention provides a manufacturing a polycycloolefin layer, comprises above mentioned steps of (1), (2), (3) and;
(4) applying one or more additional layers above the polycycloolefin layer.

It is one embodiment of the invention that the additional layers are preferably selected from the group consisting of organic layers, inorganic layers, and hybrid layers (more preferably selected from the group consisting of an inorganic layer comprising a material selected from the group consisting of silicon oxide, silicon nitride, silicon oxynitride, aluminium oxynitride, magnesium oxide, aluminium oxide, aluminium nitride, titanium oxide, titanium nitride, tantalum oxide, tantalum nitride, hafnium oxide, hafnium nitride, zirconium oxide, zirconium nitride, cerium oxide, cerium nitride, indium oxide, tin oxide, tin nitride and any blend of any of these. Further preferably such additional layers constitute of a touch panel.

### [Device manufacturing]

Without wishing to be bound by theory, polycycloolefin layer manufactured by the above-mentioned invention can have good property of transparency or flexibility. Including such polycycloolefin layer in an electronic device is advantageous. Also setting such polycycloolefin layer above a base member (preferably the base member is an electronic device) of this invention is advantageous.

This invention provides a method of manufacturing an electronic device comprising a method of manufacturing above mentioned polycycloolefin layer.

It is one embodiment of this invention that the electronic device is preferably a light emitting device (more preferably an organic light emitting device).

Preferably the light emitting device comprises in sequence a first electrode (more preferably anode), a light emitting layer, and a second electrode (more preferably cathode). Preferably the organic light emitting device comprises in sequence a first electrode (more preferably anode), a hole transport layer, a light emitting layer, an electron transport layer, and the second electrode (more preferably cathode).

For these further processing, known methods can be applied. For example, after forming the base member of this invention, if necessary, the base member is cut into chips, which are connected to a lead frame and packaged with resin. As another embodiment, the polycycloolefin layer according to this invention can constitute a layer of fabrication layers in a device (e.g., Lighting device).

This invention also provides an electronic device manufactured by the method described above.

The invention will now be described in more detail by reference to the following examples, which area illustrative only and do not limit the scope of the invention.

### Comparative Examples 1-3

Comparative compositions without (d) absorbers are prepared as follows.

In a glass bottle, Ru-I (0.0046 g) and CPTX (0.0030 g) are dissolved in PENB (10 g) without solvent to form a clear composition. 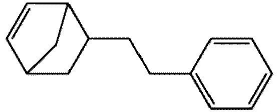 5-phenethylbicyclo[2.2.1]hept-2-ene (PENB) 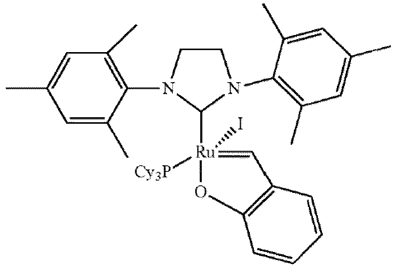 1,3-bis(2,4,6-trimethylphenylimidazolidin-2-ylidene)(tricyclohexylphospine)-(2-oxobenzylidene)ruthenium(Vl)iodide (Ru-I) 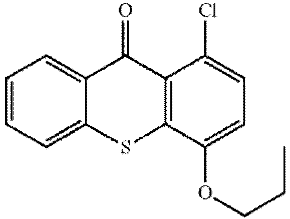 1-chloro-4-propoxy-9H-thioxanthen-9-one (CPTX)

Each composition is spin coated under nitrogen atmosphere on pre-cleaned Quartz substrates, to be wet films. The wet films are illuminated with UV light of 395 nm under nitrogen atmosphere to cure the film, the dose applied was in general between 0.5 and 5 J/cm². The dose used for the comparative examples is given in Table 1. The spin coating parameters are optimized to obtain 8 µm film thickness. The film thickness is determined by profilometry after curing the film and scratching with a scalpel to reference to the substrate surface.

After sample preparation, transmission spectra are registered in the wavelength range 250 - 800 nm.

### Working Examples 1-13 and 17 and Reference Examples 14-16

Working example and reference example compositions are prepared as follow. Except for adding (d) absorber, working example and reference example compositions are prepared in the same manner to the comparative composition 1. The amounts of (d) absorber comparting to the total of the composition are described in Table 1.

It is confirmed that working example compositions shows good transmission in visible range (450-800 nm) and UV light transmission reduction (250-450 nm).

**Table 1: Curing UV dose and transmission data for films prepared with and without UV blocker added.**

| | [wt.%] (d) absorber | Dose at 395 nm [J/cm²] | Transmission | | |
|---|---|---|---|---|---|
| | | | Minimum Transmission @ wavelength [%T @ nm] | Average Transmi ssion 250 - 450 nm [%T] | Average Transmission 450 -800 nm [%T] |
| Com Ex.1 | - | 1 | 81.2 @ 256 | 94 | 98.8 |
| Com Ex.2 | - | 1.5 | 81.7 @ 256 | 94.2 | 98.9 |
| Com Ex.3 | - | 2 | 82.2 @ 256 | 94.3 | 98.9 |
| Ex.1 | 4% LA-F70 | 2 | 38.1 @ 334 | 58.8 | 99.7 |
| Ex.2 | 8% BL1337 | 1 | 42.4 @ 367 | 75.8 | 98.6 |
| Ex.3 | 8% BL1337 | 1.5 | 42.5 @ 367 | 75.9 | 98.8 |
| Ex.4 | 4% FDB-009 | 1 | 2.0 @ 393 | 48.1 | 99.3 |
| Ex.5 | 4% FDB-009 | 1.5 | 1.4 @ 393 | 43.9 | 99.1 |
| Ex.6 | 2% LA-F70 and 2% Tinuvin970 | 1 | 6.0 @338 | 28.3 | 99 |
| Ex.7 | 2% LA-F70 and 2% Tinuvin970 | 2 | 9.5 @338 | 32.5 | 98.4 |
| Ex.8 | 1% LA-F70 and 1% Tinuvin970 | 1 | 26.9 @ 338 | 51.3 | 99 |
| Ex.9 | 1% LA-F70 and 1% Tinuvin970 | 2 | 27.5 @ 338 | 51.8 | 99 |
| Ex.10 | 4% Tinuvin970 and 2% Tinuvin928 | 2 | 3.3 @ 280 | 22 | 99 |
| Ex.11 | 1.5% Tinuvin970, 1.5% Tinuvin477 and 1.5% Tinuvin928 | 2 | 1.8 @ 340 | 28.2 | 99.3 |
| Ex.12 | 1% Tinuvin970, 1% Tinuvin477 and 1% Tinuvin928 | 2 | 7.2 @ 356 | 38.4 | 99.3 |
| Ex.13 | 8% BL1226 | 1 | 42.5 @ 367 | 75.8 | 98.6 |
| Ex.14* | 3% Absorber 01 | 1 | 10.4 @347 | 40.2 | 98.6 |
| Ex.15* | 4% Absorber 02 | 1 | 6.5 @ 346 | 32.7 | 98.3 |
| Ex.16* | 4% Absorber 03 | 1 | 9.1 @ 347 | 35.9 | 98.5 |
| Ex.17 | 3% Absorber 04 | 1 | 81.2 @255 | 91.8 | 98.7 |

| | | | | | |
|---|---|---|---|---|---|
| * reference example In above Table 1, "Com Ex." means "Comparative example". In above Table 1, simple "Ex." means "Working example" and same applies in following Table. | | | | | |

**Table 2: Structures of Absorber 01-04.**

| | |
|---|---|
| 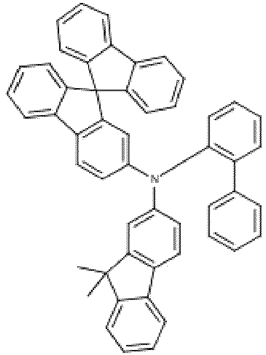 Absorber 01 | 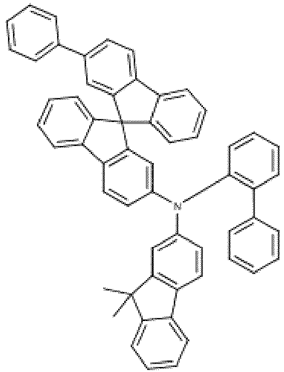 Absorber 02 |
| 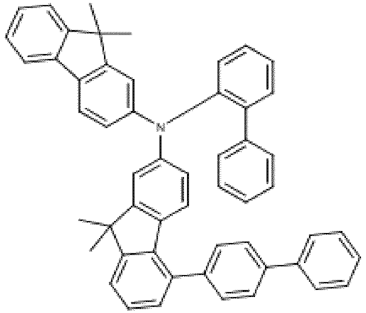 Absorber 03 | 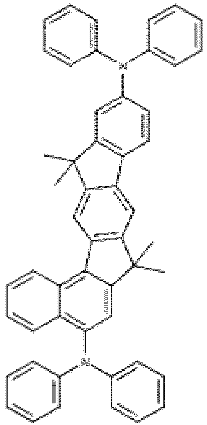 Absorber 04 |

### Working examples 18-29, 33-36 and reference examples 30-32

The solubility of the (d) absorbers is tested by each (d) absorbers dissolved in comparative example composition 1 at room temperature. This test run for a maximum of 4 weeks. Table 3 lists the compositions and their solution stability, by visual check.

**Table 3: Formulation stability at room temperature.**

| | (d) absorber | Solution stability |
|---|---|---|
| Ex.18 | 2% Tinuvin970, 2% Tinuvin477 and 2% Tinuvin928 | Not stable, turbid after 3 days |
| Ex.19 | 2% Tinuvin477 | Not stable, turbid after 3 days |
| Ex.20 | 15% Tinuvin928 | Not fully dissolved |
| Ex.21 | 8% BL1337 | Not fully dissolved |
| Ex.22 | 4% LA-F70 | Not stable, turbid after 3 days |
| Ex.23 | 4% FDB-009 | Not stable, turbid after 7 days |
| Ex.24 | 1% LA-F70 and 1% Tinuvin970 | Stable |
| Ex.25 | 2% LA-F70 and 2% Tinuvin970 | Stable |
| Ex.26 | 4% Tinuvin970 and 2% Tinuvin928 | Not stable, turbid after 7 days |
| Ex.27 | 1% Tinuvin970, 1% Tinuvin477 and 1% Tinuvin928 | Stable |
| Ex.28 | 1.5% Tinuvin970, 1.5% Tinuvin477 and 1.5% Tinuvin928 | stable |
| Ex.29 | 8% BL1226 | Stable |
| Ex.30* | 3% Absorber 01 | Stable |
| Ex.31* | 4% Absorber 02 | Stable |
| Ex.32* | 4% Absorber 03 | Stable |
| Ex.33 | 3% Absorber 04 | stable |
| Ex.34 | 4% Eusolex 9020 | Not dissolved |
| Ex.35 | 4% Oxynex ST | Not stable, turbid after 2 hours |
| Ex.36 | 4% Eusolex S | Stable |

| | | |
|---|---|---|
| * reference example | | |

## Claims

1. A composition comprising: (a) one or more monomers of formula (I); (b) a latent organo-transition metal catalyst comprising a metal selected from the group consisting of ruthenium, osmium or palladium; (c) a compound capable of releasing a Bronsted acid when subjected to photolytic conditions; and (d) an absorber compound having a maximum absorption wavelength between 280-410 nm;
wherein the formula (I) is represented by below formula; 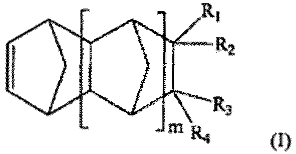
m is an integer 0, 1 or 2;
R₁, R₂, R₃ and R₄ are each independently selected from the group consisting of hydrogen, halogen, methyl, ethyl, linear or branched C₁₋₂₀ alkyl, perfluoro C₁₋₁₂ alkyl, hydroxy C₁₋₁₆ alkyl, C₃₋₁₂ cycloalkyl, C₆₋₁₂ bicycloalkyl, (CH₂)ₐ- C₆₋₁₂ bicycloalkenyl, C₇₋₁₄ tricycloalkyl, substituted or unsubstituted C₆₋₁₀ aryl, substituted or unsubstituted C₆₋₁₀ aryl C₁₋₆ alkyl, perfluoro C₆₋₁₀ aryl, perfluoro C₆₋₁₀ aryl C₁₋₃ alkyl and a group of formula (A):
-Z-Aryl (A),
wherein:
Z is a single bond or a group selected from the group consisting of:
(CR₅R₆)ₐ, O(CR₅R₆)ₐ, (CR₅R₆)ₐO, (CR₅R₆)ₐ-O-(CR₅R₆)_{b}, (CR₅R₆)ₐ-O-(SiR₅R₆)_{b}, (CR₅R₆)ₐ-(CO)O-(CR₅R₆)_{b}, where a and b are integers each independently is 1 to 12;
R₅ and R₆ are each independently selected from the group consisting of hydrogen, methyl, ethyl, linear or branched C₃₋₆ alkyl, hydroxy, methoxy, ethoxy, linear or branched C₃₋₆ alkyloxy, acetoxy, C₂₋₆ acyl,
hydroxymethyl, hydroxyethyl, linear or branched hydroxy C₃₋₆ alkyl, substituted or unsubstituted phenyl and substituted or unsubstituted phenoxy;
Aryl is phenyl or phenyl substituted with one or more of groups selected from the group consisting of methyl, ethyl, linear or branched C₃₋₆ alkyl, hydroxy, methoxy, ethoxy, linear or branched C₃₋₆ alkyloxy, acetoxy, C₂₋₆ acyl, hydroxymethyl, hydroxyethyl, linear or branched hydroxy C₃₋₆ alkyl, phenyl and phenoxy; and
optionally one of R₁ or R₂ taken together with one of R₃ or R₄ and the carbon atoms to which they are attached to form a C₅₋₇ carbocyclic ring optionally containing one or more double bonds; and
wherein the (c) compound capable of generating Bronsted acid when subjected to photolytic conditions is of the formula (V): 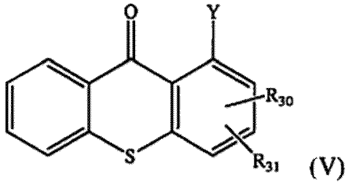
wherein Y is halogen; and
R₃₀ and R₃₁ are each independently selected from the group consisting of hydrogen, methyl, ethyl, linear or branched C₃₋₁₂ alkyl, C₃₋₁₂ cycloalkyl, C₆₋₁₂ bicycloalkyl, C₇₋₁₄ tricycloalkyl, C₆₋₁₀ aryl, C₆₋₁₀ aryl C₁₋₃ alkyl, C₁₋₁₂ alkoxy, C₃₋₁₂ cycloalkoxy, C₆₋₁₂ bicycloalkoxy, C₇₋₁₄ tricycloalkoxy, C₆₋₁₀ aryloxy C₁₋₃ alkyl and C₆₋₁₀ aryloxy;
wherein the (d) absorber compound is represented by a formula selected from the group consisting of the following formula (d-1), (d-2) and (d-3) or the (d) absorber compound is a compound selected from the group consisting of aromatic tertiary amines containing at least two tertiary amine units, tertiary amines containing carbazole units, hexa-aza-triphenylene compounds and phthalocyanine derivatives; 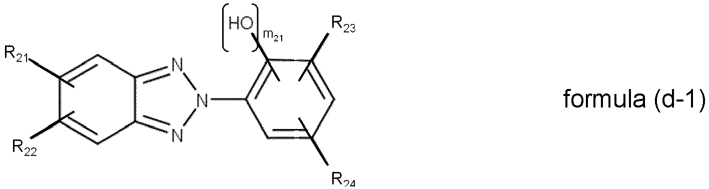
wherein R₂₁ and R₂₂ are each independently hydrogen, linear or branched C₁₋₅ alkyl or C₆₋₁₀ aryl; optionally C₁₋₅ alkyls of R₂₁ and R₂₂ can bond each other to make a saturated or unsaturated ring; optionally one or more of methylene of such saturated ring can be each independently replaced with -(C=O)- or -NR₂₅-; where R₂₅ is each dependently hydrogen, linear or branched C₁₋₅ alkyl or C₆₋₁₀ aryl;
m₂₁ is an integer of 1-3; and
R₂₃ and R₂₄ are each independently C₁₋₁₀ alkyl, C₆₋₁₈ aryl, C₆₋₁₂ aryl C₁₋₅ alkyl, or C₁₋₅ alkyl C₆₋₁₂ aryl; where alkyl portion of R₂₃ and R₂₄ can be linear or branched each independently; and optionally methylene of alkyl portion of R₂₃ and R₂₄ can be replaced with -CO-, -O-, or -COO-; 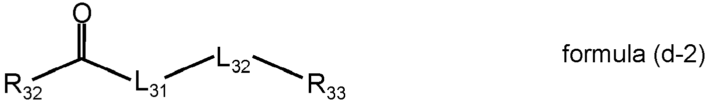
wherein R₃₂ and R₃₃ are each independently C₁₋₂₁ hydrocarbon groups which can optionally form saturated or unsaturated ring, where optionally one or more portion of carbon-carbon single bond in the compound represented by formula (d-2) (more preferably R₃₂ or R₃₃) can be replaced with carbon-carbon double bond; optionally methylene portion of the R₃₂ can be replaced with -O- or -C(=O)-;
L₃₁ is a C₁₋₁₂ hydrocarbon linker which can optionally form saturated or unsaturated ring, where optionally methylene portion of the L₃₁ can be replaced with -O-;
L₃₂ is -CO-, -CH₂-, or -CH(CH₃)-; and
at least one of methyl in the compound represented by formula (d-2) is replaced by hydroxyl or methoxy; 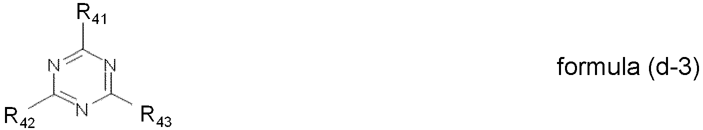
wherein R₄₁, R₄₂ and R₄₃ are each independently C₁₋₂₀ hydrocarbon groups which can optionally form saturated or unsaturated ring, where optionally methylene portion of the R₄₁, R₄₂ or R₄₃ can be replaced with -O-; where at least one of methyl in the compound represented by formula (d-3) is replaced by hydroxyl or methoxy.

2. The composition according to claim 1, wherein said composition forms a substantially transparent layer when exposed to suitable radiation; preferably the substantially transparent layer has an average transmission of 80-99.9% of the 450-800 nm wavelength light; or preferably substantially transparent layer has an average transmission of 5-60% as of the range of 250-450 nm wavelength light.

3. The composition according to claim 1 or 2, wherein said substantially transparent layer has an average transmission 90-100% of the visible light.

4. The composition according to claim 1, wherein the (d) absorber compound the (d) absorber compound is a compound selected from the group consisting of aromatic tertiary amines containing at least two tertiary amine units, tertiary amines containing carbazole units, hexa-aza-triphenylene compounds and phthalocyanine derivatives and is excited by electronic field when formed (preferably by deposition) to the layer.

5. The composition according to claim 1, wherein the (d) absorber compound is represented by a formula selected from the group consisting of the following formula (d-1), (d-2) and (d-3), and the (d) absorber works to block UV by a mechanism of Exited state intramolecular proton transfer (ESIPT).

6. The composition according to one or more of claims 1-5, wherein the (a) monomer of formula (I) is formula (I-a) 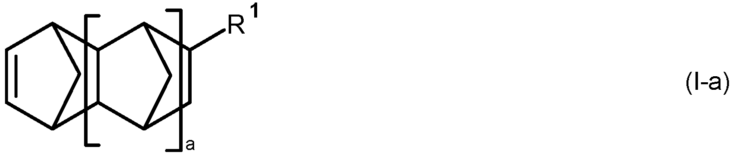 with a being 0 or 1, and R¹ being a linear or branched C₁₋₂₀ alkyl group or an unsubstituted C₆₋₁₀ aryl C₁₋₆ alkyl.

7. The composition according to one or more of claims 1-6, wherein the (a) monomer of formula (I) is selected from the group consisting of the following formula (I-a-01) to (I-a-21):
| | | |
|---|---|---|
| 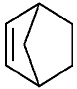 | NB | (I-a-01) |
| 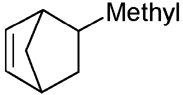 | MeNB | (I-a-02) |
| 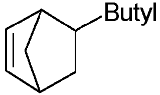 | BuNB | (I-a-03) |
| 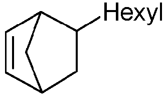 | HexNB | (I-a-04) |
| 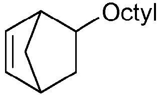 | OctNB | (I-a-05) |
| 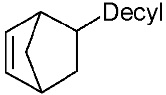 | DecNB | (I-a-06) |
| 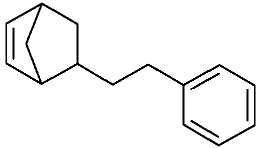 | PENB | (I-a-07) |
| 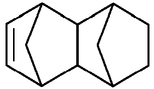 | TD | (I-a-08) |
| 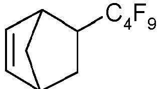 | NBC₄F₉ | (I-a-09) |
| 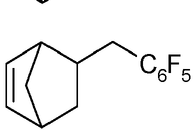 | NBCH₂C₆F₅ | (I-a-10) |
| 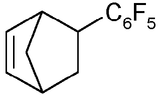 | NBC₆F₅ | (I-a-11) |
| 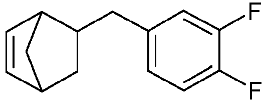 | NBCH₂C₆H₃F₂ | (I-a-12) |
| 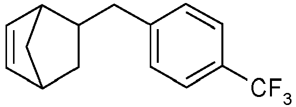 | NBCH₂C₆H₄C F₃ | (I-a-13) |
| 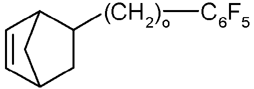 | NBalkylC₆F₅ | (I-a-14) |
| 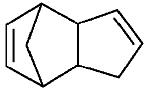 | DCPD | (I-a-15) |
| 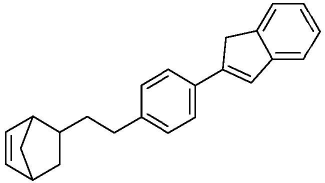 | EtPhIndNB | (I-a-16) |
| 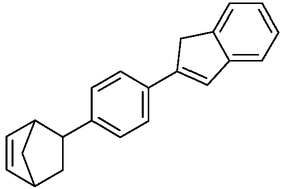 | PhIndNB | (I-a-17) |
| 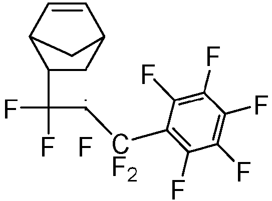 | PFBTCNB | (I-a-18) |
| | PMNB | (I-a-19) |
| 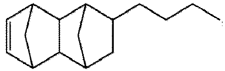 | ButylTD | (I-a-20) |
| 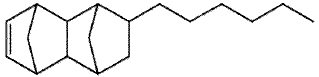 | HexylTD | (I-a-21) |
| 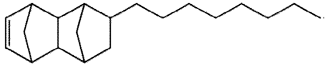 | OctylTD | (I-a-22) |

8. The composition according to one or more of claims 1-7, wherein the latent catalyst is an organo- ruthenium compound selected from the group consisting of a compound of formula (IIA), a compound of formula (IIB), a compound of formula (IIIA), a compound of formula (IIIB), a compound of formula (IIIC), and a compound of formula (IIID): 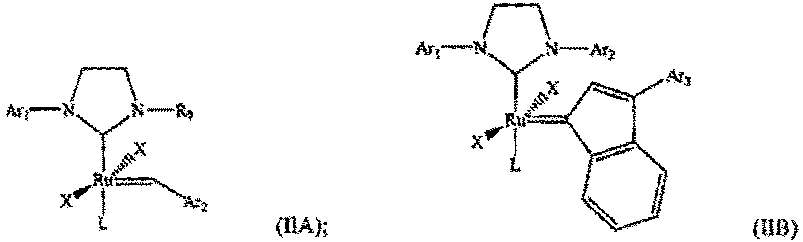 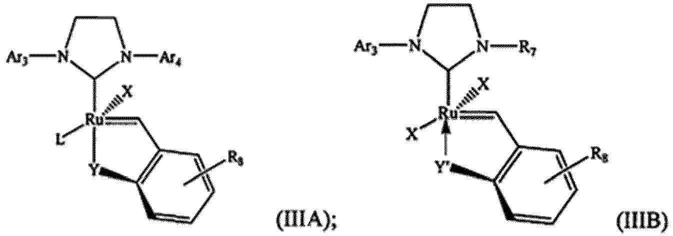 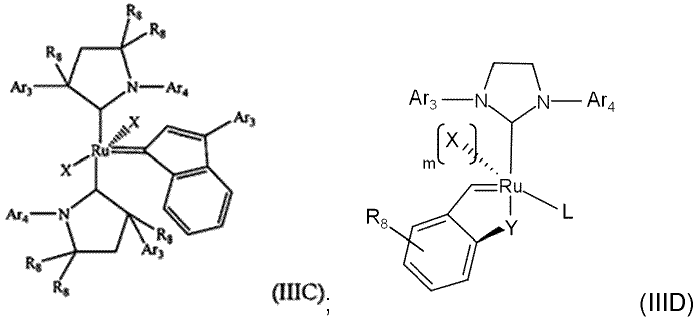 wherein:
X is each independently selected from the group consisting of chlorine, bromine, iodine, -ORₐ, -O(CO)Rₐ, -S(Rₐ)₂, -OSO₂Rₐ and -N(Rₐ)₂, where Rₐ is each independently selected from the group consisting of single bond, C₁₋₁₂ alkyl, C₃₋₁₂ cycloalkyl, C₆₋₁₄ aryl and =CH(Rₐ');
where any combination of two combination Rₐs can bond each other;
and Rₐ' is a single bond which binds to Rₐ or L,
Y is selected from the group consisting of O, S and NCOCF₃;
Y' is selected from the group consisting of OR₉, SR₉ and - N=CHC(O)O(C₁₋₆ alkyl), where R₉ is selected from the group consisting of methyl, ethyl, linear or branched C₁₋₆ alkyl, C₆₋₁₀ aryl, methoxy, ethoxy, linear or branched C₁₋₆ alkoxy, C₆₋₁₀ aryloxy and - OCH(CH₃)C(O)N(CH₃)(OCH₃);
L is selected from the group consisting of pyridine, PR₃, 0=PR₃ and -OR₃, where each R₃ is independently selected from the group consisting of isopropyl, sec-butyl, tert-butyl, cyclohexyl, bicyclo C₅₋₁₀ alkyl, phenyl, benzyl, isopropoxy, sec-butoxy, tert-butoxy, cyclohexyloxy, phenoxy and benzyloxy;
where one of X and L can form a anionic ligand of the formula X-L;
R₇ is selected from the group consisting of isopropyl, sec-butyl, tert-butyl, substituted or unsubstituted cyclohexyl, substituted or unsubstituted phenyl, substituted or unsubstituted biphenyl and substituted or unsubstituted naphthyl;
R₈ is selected from the group consisting of hydrogen, chlorine, methyl, ethyl, linear or branched C₁₋₆ alkyl, C₆₋₁₀ aryl, methoxy, ethoxy, linear or branched C₁₋₆ alkoxy, C₆₋₁₀ aryloxy, -NHCO(C₁₋₆)alkyl, -NHCO-perfluoro(C₁₋₆)alkyl, -SO₂N((C₁₋₆)alkyl)₂ and -NO₂;
Ar₁, Ar₂ Ar₃ and Ar₄ are each independently selected from the group consisting of substituted or unsubstituted phenyl, substituted or unsubstituted biphenyl and substituted or unsubstituted naphthyl;
wherein said substituents are each independently selected from the group consisting of methyl, ethyl, iso-propyl, tert-butyl, phenyl and OSi(SiMe₃)₃;
m is a integer of 1, 2 or 3.

9. The composition according to one or more of claims 1-8, wherein the content of the (a) monomer is 80-99.99 mass % based on the composition;
preferably the content of the (b) latent organo-transition metal catalyst is 0.0001-1.0 mass % based on the composition;
preferably the content of the (c) compound capable of releasing a Bronsted acid is 0.0001-1.0 mass % based on the composition; or
preferably the content of the (d) absorber compound is 0.5-15 mass % based on the composition.

10. A method of manufacturing a polycycloolefin layer comprising steps of;
(1) preparing a base member;
(2) applying the composition according to any one or more of claims 1 to 9 above the base member; and
(3) polymerizing the (a) monomers in the composition.

11. The method of manufacturing a polycycloolefin layer according to claim 10; where the permittivity of the polycycloolefin layer is 3 or less.

12. The method of manufacturing a polycycloolefin layer according to claim 10 or 11; wherein the measure of applying the composition in step (2) is selected from the group consisting of deposition, dip coating, spin coating, ink jet printing, nozzle printing, letter-press printing, screen printing, gravure printing, doctor blade coating, roller printing, reverse-roller printing, offset lithography printing, dry offset lithography printing, flexographic printing, web printing, spray coating, curtain coating, brush coating, slot dye coating and pad printing; and
preferably deposition, ink jet printing or nozzle printing.

13. The method of manufacturing a polycycloolefin layer according to any one or more of claims 10 to 12; wherein the step (3) is performed by irradiation and/or heat.

14. The method of manufacturing a polycycloolefin layer according to any one or more of claims 10 to 13; further comprising the step of (4) applying one or more additional layers above the polycycloolefin layer;
preferably the additional layers are selected from the group consisting of organic layers, inorganic layers and hybrid layers;
preferably the additional layers are selected from the group consisting of an inorganic layer comprising a material selected from the group consisting of silicon oxide, silicon nitride, silicon oxynitride, aluminum oxynitride, magnesium oxide, aluminum oxide, aluminum nitride, titanium oxide, titanium nitride, tantalum oxide, tantalum nitride, hafnium oxide, hafnium nitride, zirconium oxide, zirconium nitride, cerium oxide, cerium nitride, tin oxide, tin nitride and any blend of any of these; or
preferably additional layers constitutes of a touch panel.

15. A method of manufacturing an electronic device comprising;
a method of manufacturing a polycycloolefin layer according to any one or more of claims 10 to 14.

16. The method of manufacturing an electronic device according to claim 15, wherein the base member of the method of manufacturing a polycycloolefin is an electronic device;
preferably the electronic device is a light emitting device (more preferably an organic light emitting device);
preferably the light emitting device comprises in sequence a first electrode (more preferably anode), a light emitting layer, and a second electrode (more preferably cathode); or
preferably the organic light emitting device comprises in sequence a first electrode (more preferably anode), a hole transport layer, a light emitting layer, an electron transport layer, and the second electrode (more preferably cathode).

17. An electronic device manufactured by the method according to claim 15 or 16.

## Patentansprüche

1. Zusammensetzung enthaltend: (a) ein oder mehrere Monomere der Formel (I); (b) einen latenten organischen Übergangsmetallkatalysator enthaltend ein Metall, das ausgewählt ist aus der Gruppe bestehend aus Ruthenium, Osmium oder Palladium; (c) eine Verbindung, die zur Freisetzung einer Brönsted-Säure befähigt ist, wenn sie photolytischen Bedingungen unterworfen wird; und (d) eine Absorberverbindung mit einer maximalen Absorptionswellenlänge zwischen 280-410 nm; bei der die Formel (I) durch die nachstehende Formel dargestellt wird; 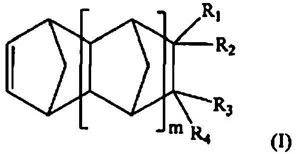
m eine ganze Zahl 0, 1 oder 2 ist;
R₁, R₂, R₃ und R₄ jeweils unabhängig ausgewählt sind aus der Gruppe bestehend aus Wasserstoff, Halogen, Methyl, Ethyl, linearem oder verzweigtem C₁₋₂₀-Alkyl, Perfluor-C₁₋₁₂-alkyl, Hydroxy-C₁₋₁₆-alkyl, C₃₋₁₂-Cycloalkyl, C₆₋₁₂-Bicycloalkyl, (CH₂)ₐ-C₆₋₁₂-Bicycloalkenyl, C₇₋₁₄-Tricyclo-alkyl, substituiertem oder unsubstituiertem C₆₋₁₀-Aryl, substituiertem oder unsubstituiertem C₆₋₁₀-Aryl-C₁₋₆-alkyl, Perfluor-C₆₋₁₀-aryl, Perfluor-C₆₋₁₀-aryl-C₁₋₃-alkyl und einer Gruppe der Formel (A):
-Z-Aryl (A),
bei der:
Z eine Einfachbindung oder eine Gruppe ist, die ausgewählt ist aus der Gruppe bestehend aus: (CR₅R₆)ₐ, O(CR₅R₆)ₐ, (CR₅R₆)ₐO, (CR₅R₆)ₐ-O-(CR₅R₆)_{b}, (CR₅R₆)ₐ-O-(SiR₅R₆)_{b}, (CR₅R₆)ₐ-(CO)O-(CR₅R₆)_{b}, wobei a und b ganze Zahlen sind, die jeweils unabhängig 1 bis 12 sind;
R₅ und R₆ jeweils unabhängig ausgewählt sind aus der Gruppe bestehend aus Wasserstoff, Methyl, Ethyl, linearem oder verzweigtem C₃₋₆-Alkyl, Hydroxy, Methoxy, Ethoxy, linearem oder verzweigtem C₃₋₆-Alkyloxy, Acetoxy, C₂₋₆-Acyl, Hydroxymethyl, Hydroxyethyl, linearem oder verzweigtem Hydroxy-C₃₋₆-alkyl, substituiertem oder unsubstituiertem Phenyl und substituiertem oder unsubstituiertem Phenoxy;
Aryl Phenyl oder mit einer oder mehreren aus der Gruppe bestehend aus Methyl, Ethyl, linearem oder verzweigtem C₃₋₆-Alkyl, Hydroxy, Methoxy, Ethoxy, linearem oder verzweigtem C₃₋₆-Alkyloxy, Acetoxy, C₂₋₆-Acyl, Hydroxymethyl, Hydroxyethyl, linearem oder verzweigtem Hydroxy-C₃₋₆-alkyl, Phenyl und Phenoxy ausgewählten Gruppen substituiertes Phenyl ist; und
gegebenenfalls einer von R₁ oder R₂ zusammengenommen mit einem von R₃ oder R₄ und den Kohlenstoffatomen, an die sie gebunden sind, einen carbocyclischen C₅₋₇-Ring bildet, der gegebenenfalls eine oder mehrere Doppelbindungen enthält; und
bei der die Verbindung (c), die zur Erzeugung einer Brönsted-Säure befähigt ist, wenn sie photolytischen Bedingungen unterworfen wird, die Formel (V) aufweist: 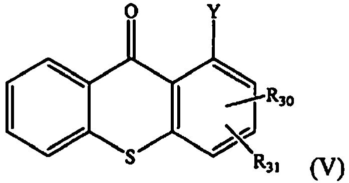
bei der Y Halogen ist; und
R₃₀ und R₃₁ jeweils unabhängig ausgewählt sind aus der Gruppe bestehend aus Wasserstoff, Methyl, Ethyl, linearem oder verzweigtem C₃₋₁₂-Alkyl, C₃₋₁₂-Cycloalkyl, C₆₋₁₂-Bicycloalkyl, C₇₋₁₄-Tricycloalkyl, C₆₋₁₀-Aryl, C₆₋₁₀-Aryl-C₁₋₃-alkyl, C₁₋₁₂-Alkoxy, C₃₋₁₂-Cycloalkoxy, C₆₋₁₂-Bicycloalkoxy, C₇₋₁₄-Tricycloalkoxy, C₆₋₁₀-Aryloxy-C₁₋₃-alkyl und C₆₋₁₀-Aryloxy;
bei der die Absorberverbindung (d) dargestellt wird durch eine Formel, die ausgewählt ist aus der Gruppe bestehend aus den folgenden Formeln (d-1), (d-2) und (d-3), oder die Absorberverbindung (d) eine Verbindung ist, die ausgewählt ist aus der Gruppe bestehend aus mindestens zwei tertiäre Amineinheiten enthaltenden aromatischen tertiären Aminen, Carbazoleinheiten enthaltenden tertiären Aminen, Hexa-aza-triphenylen-Verbindungen und Phthalocyaninderivaten; 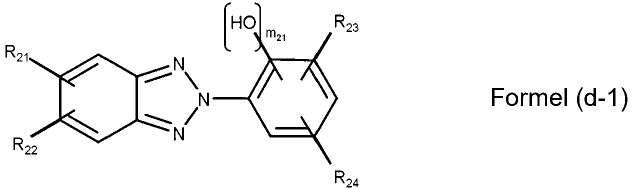
bei der R₂₁ und R₂₂ jeweils unabhängig Wasserstoff, lineares oder verzweigtes C₁₋₅-Alkyl oder C₆₋₁₀-Aryl sind; gegebenenfalls können C₁₋₅-Alkyle von R₂₁ und R₂₂ miteinander zu einem gesättigten oder ungesättigten Ring verbunden sein; gegebenenfalls können ein oder mehrere Methylene eines solchen gesättigten Rings jeweils unabhängig durch -(C=O)- oder -NR₂₅- ersetzt sein; wobei R₂₅ jeweils abhängig Wasser-stoff, lineares oder verzweigtes C₁₋₅-Alkyl oder C₆₋₁₀-Aryl ist;
m₂₁ eine ganze Zahl von 1-3 ist; und
R₂₃ und R₂₄ jeweils unabhängig C₁₋₁₀-Alkyl, C₆₋₁₈-Aryl, C₆₋₁₂-Aryl-C₁₋₅-alkyl oder C₁₋₅-Alkyl-C₆₋₁₂-aryl sind; wobei der Alkylteil von R₂₃ und R₂₄ jeweils unabhängig linear oder verzweigt sein kann; und gegebenenfalls Methylen des Alkylteils von R₂₃ und R₂₄ durch -CO-, -O- oder -COO- ersetzt sein kann; 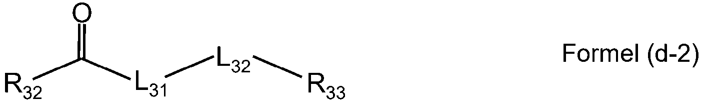
bei der R₃₂ und R₃₃ jeweils unabhängig C₁₋₂₁-Kohlenwasserstoffgruppen sind, die gegebenenfalls einen gesättigten oder ungesättigten Ring bilden können, wobei gegebenenfalls ein oder mehrere Teile einer Kohlenstoff-Kohlenstoff-Einfachbindung in der durch die Formel (d-2) dargestellten Verbindung (stärker bevorzugt R₃₂ oder R₃₃) durch eine Kohlenstoff-Kohlenstoff-Doppelbindung ersetzt sein können;
gegebenenfalls kann der Methylenteil von R₃₂ durch -O- oder -C(=O)-ersetzt sein;
L₃₁ ein C₁₋₁₂-Kohlenwasserstofflinker ist, der gegebenenfalls einen gesättigten oder ungesättigten Ring bilden kann, wobei gegebenenfalls der Methylenteil von L₃₁ durch -O- ersetzt sein kann;
L₃₂ -CO-, -CH₂- oder -CH(CH₃)- ist; und
mindestens eines der Methyle in der durch die Formel (d-2) dargestellten Verbindung durch Hydroxy oder Methoxy ersetzt ist; 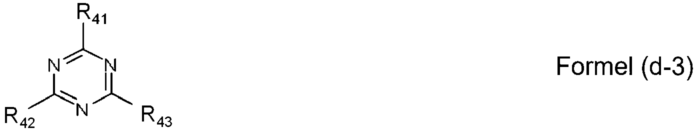
bei der R₄₁, R₄₂ und R₄₃ jeweils unabhängig C₁₋₂₀-Kohlenwasserstoff-gruppen sind, die gegebenenfalls einen gesättigten oder ungesättigten Ring bilden können, worin gegebenenfalls der Methylenteil von R₄₁, R₄₂ oder R₄₃ durch -O- ersetzt sein kann; wobei mindestens eines der Methyle in der durch die Formel (d-3) dargestellten Verbindung durch Hydroxy oder Methoxy ersetzt ist.

2. Zusammensetzung nach Anspruch 1, bei der die Zusammensetzung eine im Wesentlichen transparente Schicht bildet, wenn sie geeigneter Strahlung ausgesetzt wird;
die im Wesentlichen transparente Schicht vorzugsweise eine durchschnittliche Transmission von 80-99,9 % des Lichts der Wellenlänge 450-800 nm aufweist; oder
die im Wesentlichen transparente Schicht vorzugsweise eine durchschnittliche Transmission von 5-60 % des Lichts im Wellenlängenbereich von 250-450 nm aufweist.

3. Zusammensetzung nach Anspruch 1 oder 2, bei der die im Wesentlichen transparente Schicht eine durchschnittliche Transmission von 90-100 % des sichtbaren Lichts aufweist.

4. Zusammensetzung nach Anspruch 1, bei der die Absorberverbindung (d) eine Verbindung ist, die ausgewählt ist aus der Gruppe bestehend aus mindestens zwei tertiäre Amineinheiten enthaltenden aromatischen tertiären Aminen, Carbazoleinheiten enthaltenden tertiären Aminen, Hexa-aza-triphenylen-Verbindungen und Phthalocyaninderivaten, und durch ein elektronisches Feld angeregt wird, wenn sie (vorzugsweise durch Abscheidung) die Schicht bildet.

5. Zusammensetzung nach Anspruch 1, bei der die Absorberverbindung (d) durch eine Formel dargestellt wird, die ausgewählt ist aus der Gruppe bestehend aus den folgenden Formeln (d-1), (d-2) und (d-3), und die Absorberverbindung (d) die UV-Blockierung durch einen Mechanismus des intramolekularen Protonentransfers im angeregten Zustand (excited state intramolecular proton transfer - ESIPT) bewirkt.

6. Zusammensetzung nach einem oder mehreren der Ansprüche 1-5, bei der das Monomer (a) der Formel (I) die Formel (I-a) 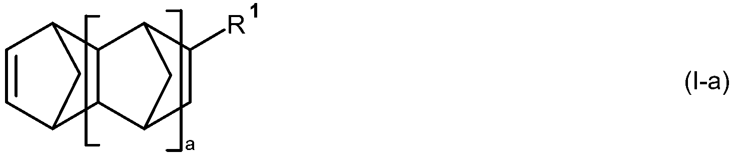 aufweist, wobei a 0 oder 1 ist und R¹ eine lineare oder verzweigte C₁₋₂₀-Alkylgruppe oder ein unsubstituiertes C₆₋₁₀-Aryl-C₁₋₆-alkyl ist.

7. Zusammensetzung nach einem oder mehreren der Ansprüche 1-6, bei der das Monomer (a) der Formel (I) ausgewählt ist aus der Gruppe bestehend aus den folgenden Formeln (I-a-01) bis (I-a-21):
| | | |
|---|---|---|
| 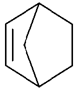 | NB | (I-a-01) |
| 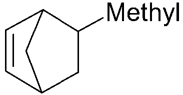 | MeNB | (I-a-02) |
| 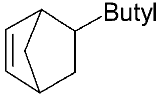 | BuNB | (I-a-03) |
| 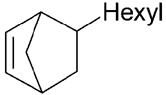 | HexNB | (I-a-04) |
| 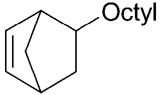 | OctNB | (I-a-05) |
| 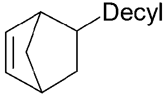 | DecNB | (I-a-06) |
| 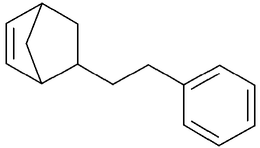 | PENB | (I-a-07) |
| 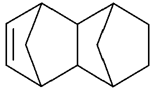 | TD | (I-a-08) |
| 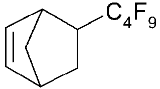 | NBC₄F₉ | (I-a-09) |
| 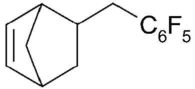 | NBCH₂C₆F₅ | (I-a-10) |
| 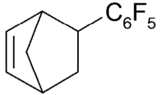 | NBC₆F₅ | (I-a-11) |
| 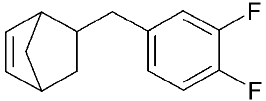 | NBCH₂C₆H₃F₂ | (I-a-12) |
| 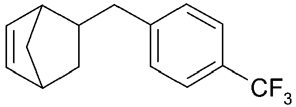 | NBCH₂C₆H₄CF₃ | (I-a-13) |
| 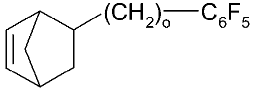 | NBalkylC₆F₅ | (I-a-14) |
| 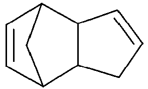 | DCPD | (I-a-15) |
| 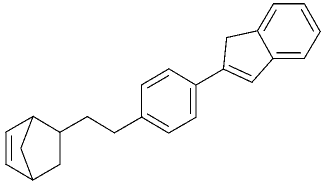 | EtPhlndNB | (I-a-16) |
| 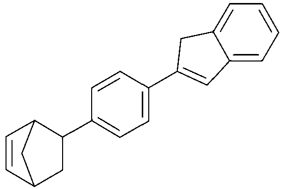 | PhlndNB | (I-a-17) |
| 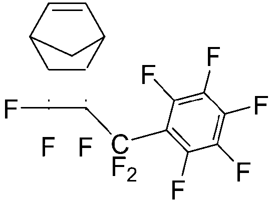 | PFBTCNB | (I-a-18) |
| | PMNB | (I-a-19) |
| 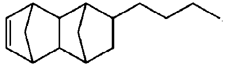 | ButylTD | (I-a-20) |
| 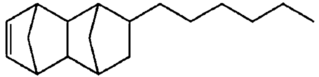 | HexylTD | (I-a-21) |
| 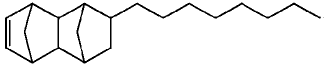 | OctylTD | (I-a-22) |

8. Zusammensetzung nach einem oder mehreren der Ansprüche 1-7, bei der der latente Katalysator eine organische Rutheniumverbindung ist, die ausgewählt ist aus der Gruppe bestehend aus einer Verbindung der Formel (IIA), einer Verbindung der Formel (IIB), einer Verbindung der Formel (IIIA), einer Verbindung der Formel (IIIB), einer Verbindung der Formel (IIIC) und einer Verbindung der Formel (IIID): 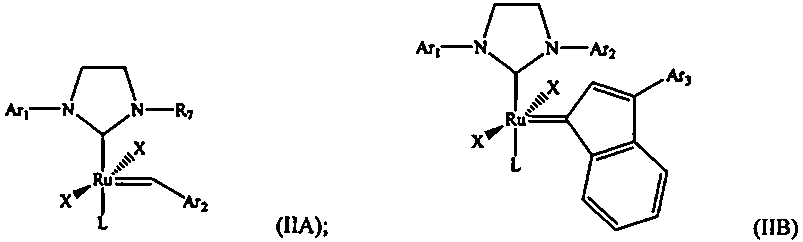 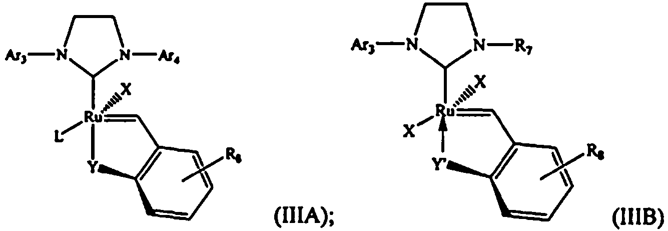 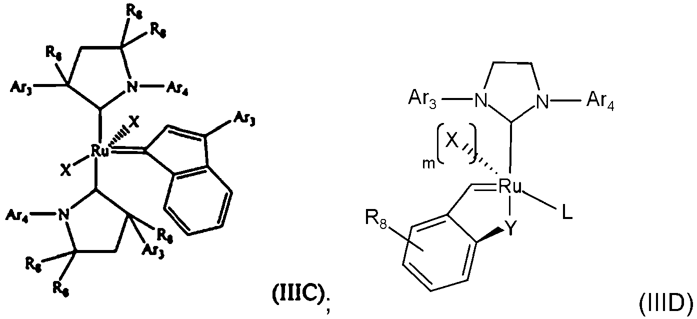 bei denen:
X jeweils unabhängig ausgewählt ist aus der Gruppe bestehend aus Chlor, Brom, lod, -ORₐ, -O(CO)Rₐ, -S(Rₐ)₂, -OSO₂Rₐ und -N(Rₐ)₂, wobei Rₐ jeweils unabhängig ausgewählt ist aus der Gruppe bestehend aus Einfachbindung, C₁₋₁₂-Alkyl, C₃₋₁₂-Cycloalkyl, C₆₋₁₄-Aryl und =CH(Rₐ');
wobei beliebige Kombinationen von zwei kombinierten Rₐ miteinander verbunden sein können; und Rₐ' eine Einfachbindung ist, die an Rₐ oder L bindet,
Y aus der Gruppe bestehend aus O, S und NCOCF₃ ausgewählt ist;
Y' aus der Gruppe bestehend aus OR₉, SR₉ und -N=CHC(O)O(C₁₋₆-Alkyl) ausgewählt ist, wobei R₉ ausgewählt ist aus der Gruppe bestehend aus Methyl, Ethyl, linearem oder verzweigtem C₁₋₆-Alkyl, C₆₋₁₀-Aryl, Methoxy, Ethoxy, linearem oder verzweigtem C₁₋₆-Alkoxy, C₆₋₁₀-Aryloxy und -OCH(CH₃)C(O)N(CH₃)(OCH₃);
L ausgewählt ist aus der Gruppe bestehend aus Pyridin, PR₃, O=PR₃ und -O-R₃, wobei R₃ jeweils unabhängig ausgewählt ist aus der Gruppe bestehend aus Isopropyl, sec-Butyl, tert-Butyl, Cyclohexyl, Bicyclo-C₅-₁₀-alkyl, Phenyl, Benzyl, Isopropoxy, sec-Butoxy, tert-Butoxy, Cyclohexyloxy, Phenoxy und Benzyloxy;
wobei einer von X und L einen anionischen Liganden der Formel X-L bilden können;
R₇ ausgewählt ist aus der Gruppe bestehend aus Isopropyl, sec-Butyl, tert-Butyl, substituiertem oder unsubstituiertem Cyclohexyl, substituiertem oder unsubstituiertem Phenyl, substituiertem oder unsubstituiertem Biphenyl und substituiertem oder unsubstituiertem Naphthyl;
R₈ ausgewählt ist aus der Gruppe bestehend aus Wasserstoff, Chlor, Methyl, Ethyl, linearem oder verzweigtem C₁₋₆-Alkyl, C₆₋₁₀-Aryl, Methoxy, Ethoxy, linearem oder verzweigtem C₁₋₆-Alkoxy, C₆₋₁₀-Aryloxy, -NHCO(C₁₋₆)-Alkyl, -NHCO-Perfluor-(C₁₋₆)-alkyl, -SO₂N((C₁₋₆)-Alkyl)₂ und -NO₂;
Ar₁, Ar₂, Ar₃ und Ar₄ jeweils unabhängig ausgewählt sind aus der Gruppe bestehend aus substituiertem oder unsubstituiertem Phenyl, substituiertem oder unsubstituiertem Biphenyl und substituiertem oder unsubstituiertem Naphthyl;
bei denen die Substituenten jeweils unabhängig ausgewählt sind aus der Gruppe bestehend aus Methyl, Ethyl, Isopropyl, tert-Butyl, Phenyl und OSi(SiMe₃)₃;
m eine ganze Zahl 1, 2 oder 3 ist.

9. Zusammensetzung nach einem oder mehreren der Ansprüche 1-8, bei der der Gehalt des Monomers (a) 80-99,99 Massen-% beträgt, bezogen auf die Zusammensetzung;
der Gehalt des latenten organischen Übergangsmetallkatalysators (b) vorzugsweise 0,0001-1,0 Massen-% beträgt, bezogen auf die Zusammensetzung;
der Gehalt der zur Freisetzung einer Brönsted-Säure befähigten Verbindung (c) vorzugsweise 0,0001-1,0 Massen-% beträgt, bezogen auf die Zusammensetzung; oder
der Gehalt der Absorberverbindung (d) vorzugsweise 0,5-15 Massen-% beträgt, bezogen auf die Zusammensetzung.

10. Verfahren zur Herstellung einer Polycycloolefinschicht umfassend die Schritte:
(1) Vorbereiten eines Grundelements;
(2) Aufbringen der Zusammensetzung nach einem oder mehreren beliebigen der Ansprüche 1 bis 9 auf das Grundelement; und
(3) Polymerisieren der Monomere (a) in der Zusammensetzung.

11. Verfahren zur Herstellung einer Polycycloolefinschicht nach Anspruch 11, wobei die Permittivität der Polycycloolefinschicht 3 oder weniger beträgt.

12. Verfahren zur Herstellung einer Polycycloolefinschicht nach Anspruch 10 oder 11, bei dem die Maßnahme zum Aufbringen der Zusammensetzung in Schritt (2) ausgewählt ist aus der Gruppe bestehend aus Abscheidung, Tauchbeschichtung, Schleuderbeschichtung, Tintenstrahldruck, Düsendruck, Hochdruck, Siebdruck, Tiefdruck, Rakelbeschichtung, Walzendruck, Umkehrwalzendruck, Offsetlithographiedruck, Trockenoffsetlithographiedruck, Flexodruck, Rollendruck, Spraycoating, Vorhangbeschichten, Brushcoating, Schlitzdüsenbeschichtung und Tampondruck; und
vorzugsweise Abscheidung, Tintenstrahldruck oder Düsendruck.

13. Verfahren zur Herstellung einer Polycycloolefinschicht nach einem oder mehreren beliebigen der Ansprüche 10 bis 12, bei dem Schritt (3) durch Bestrahlung und/oder Wärme durchgeführt wird.

14. Verfahren zur Herstellung einer Polycycloolefinschicht nach einem oder mehreren beliebigen der Ansprüche 10 bis 13, ferner umfassend den Schritt
(4)Aufbringen einer oder mehrerer zusätzlicher Schichten über der Polycycloolefinschicht;
vorzugsweise sind die zusätzlichen Schichten ausgewählt aus der Gruppe bestehend aus organischen Schichten, anorganischen Schichten und Hybridschichten;
vorzugsweise sind die zusätzlichen Schichten ausgewählt aus der Gruppe bestehend aus einer anorganischen Schicht, die ein Material enthält, das ausgewählt ist aus der Gruppe bestehend aus Siliciumoxid, Siliciumnitrid, Siliciumoxynitrid, Aluminiumoxynitrid, Magnesiumoxid, Aluminiumoxid, Aluminiumnitrid, Titanoxid, Titannitrid, Tantaloxid, Tantalnitrid, Hafniumoxid, Hafniumnitrid, Zirconoxid, Zirconnitrid, Ceroxid, Cernitrid, Zinnoxid, Zinnnitrid und beliebigen Mischungen von beliebigen hiervon; oder
vorzugsweise bilden die zusätzlichen Schichten ein Tastfeld.

15. Verfahren zur Herstellung einer elektronischen Vorrichtung, umfassend:
ein Verfahren zur Herstellung einer Polycycloolefinschicht nach einem oder mehreren beliebigen der Ansprüche 10 bis 14.

16. Verfahren zur Herstellung einer elektronischen Vorrichtung nach Anspruch 15, bei dem das Grundelement des Verfahrens zur Herstellung eines Polycycloolefins eine elektronische Vorrichtung ist;
die elektronische Vorrichtung vorzugsweise eine lichtemittierende Vorrichtung (stärker bevorzugt eine organische lichtemittierende Vorrichtung) ist;
die lichtemittierende Vorrichtung vorzugsweise aufeinanderfolgend eine erste Elektrode (stärker bevorzugt Anode), eine lichtemittierende Schicht und eine zweite Elektrode (stärker bevorzugt Kathode) umfasst; oder
die organische lichtemittierende Vorrichtung vorzugsweise aufeinanderfolgend eine erste Elektrode (stärker bevorzugt Anode), eine Lochtransportschicht, eine lichtemittierende Schicht, eine Elektronentransportschicht und die zweite Elektrode (stärker bevorzugt Kathode) umfasst.

17. Elektronischen Vorrichtung hergestellt durch das Verfahren nach Anspruch 15 oder 16.

## Revendications

1. Composition comprenant : (a) un ou plusieurs monomères de formule (I) ; (b) un catalyseur latent organométallique à base de métal de transition comprenant un métal choisi dans le groupe constitué par le ruthénium, l'osmium ou le palladium ; (c) un composé capable de libérer un acide de Brønsted lorsqu'il est soumis à des conditions photolytiques ; et (d) un composé absorbant ayant une longueur d'onde d'absorption maximale de 280-410 nm ;
où la formule (I) est représentée par la formule ci-après ; 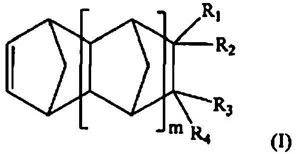
m est un nombre entier valant 0, 1 ou 2 ;
R₁, R₂, R₃ et R₄ sont choisis chacun indépendamment dans le groupe constitué par hydrogène, halogène, méthyle, éthyle, C₁₋₂₀ alkyle linéaire ou ramifié, C₁₋₁₂ alkyle perfluoré, hydroxy C₁₋₁₆ alkyle, C₃₋₁₂ cycloalkyle, C₆₋₁₂ bicycloalkyle, (CH₂)ₐ- C₆₋₁₂ bicycloalcényle, C₇₋₁₄ tricycloalkyle, C₆₋₁₀ aryle substitué ou non substitué, C₆₋₁₀ aryl C₁₋₆ alkyle substitué ou non substitué, C₆₋₁₀ aryle perfluoré, C₆₋₁₀ aryl C₁₋₃ alkyle perfluoré et un groupement de formule (A) :
-Z-Aryle (A),
où :
Z est une liaison simple ou un groupement choisi dans le groupe constitué par : (CR₅R₆)ₐ, O(CR₅R₆)ₐ, (CR₅R₆)ₐO, (CR₅R₆)ₐ-O-(CR₅R₆)_{b}, (CR₅R₆)ₐ-O-(SiR₅R₆)_{b}, (CR₅R₆)ₐ-(CO)O-(CR₅R₆)_{b}, où a et b sont des nombres entiers allant chacun indépendamment de 1 à 12 ;
R₅ et R₆ sont choisis chacun indépendamment dans le groupe constitué par hydrogène, méthyle, éthyle, C₃₋₆ alkyle linéaire ou ramifié, hydroxy, méthoxy, éthoxy, C₃₋₆ alkyloxy linéaire ou ramifié, acétoxy, C₂₋₆ acyle, hydroxyméthyle, hydroxyéthyle, hydroxy C₃₋₆ alkyle linéaire ou ramifié, phényle substitué ou non substitué et phénoxy substitué ou non substitué ;
Aryle est phényle ou phényle substitué par un ou plusieurs groupements choisis dans le groupe constitué par méthyle, éthyle, C₃₋₆ alkyle linéaire ou ramifié, hydroxy, méthoxy, éthoxy, C₃₋₆ alkyloxy linéaire ou ramifié, acétoxy, C₂₋₆ acyle, hydroxyméthyle, hydroxyéthyle, hydroxy C₃₋₆ alkyle linéaire ou ramifié, phényle et phénoxy ; et
éventuellement l'un parmi R₁ ou R₂ pris conjointement avec l'un parmi R₃ ou R₄ et les atomes de carbone auxquels ils sont fixés forme un cycle C₅₋₇ carbocyclique contenant éventuellement une ou plusieurs doubles liaisons ; et
où le composé (c) capable de générer un acide de Brønsted lorsqu'il est soumis à des conditions photolytiques répond à la formule (V) : 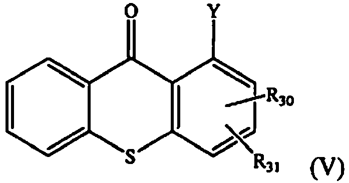
dans laquelle Y est halogène ; et
R₃₀ et R₃₁ sont choisis chacun indépendamment dans le groupe constitué par hydrogène, méthyle, éthyle, C₃₋₁₂ alkyle linéaire ou ramifié, C₃₋₁₂ cycloalkyle, C₆₋₁₂ bicycloalkyle, C₇₋₁₄ tricycloalkyle, C₆₋₁₀ aryle, C₆₋₁₀ aryl C₁₋₃ alkyle, C₁₋₁₂ alcoxy, C₃₋₁₂ cycloalcoxy, C₆₋₁₂ bicycloalcoxy, C₇₋₁₄ tricycloalcoxy, C₆₋₁₀ aryloxy C₁₋₃ alkyle et C₆₋₁₀ aryloxy ;
où le composé absorbant (d) est représenté par une formule choisie dans le groupe constitué par les formules (d-1), (d-2) et (d-3) suivantes ou le composé absorbant (d) est un composé choisi dans le groupe constitué par les amines tertiaires aromatiques contenant au moins deux motifs amine tertiaire, les amines tertiaires contenant des motifs carbazole, les composés d'hexa-aza-triphénylène et les dérivés de phtalocyanine ; 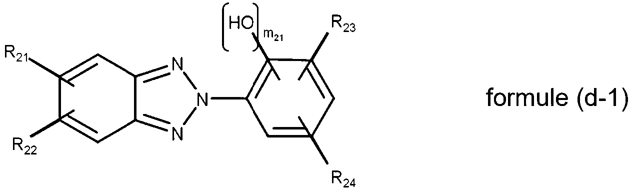
dans laquelle R₂₁ et R₂₂ sont chacun indépendamment hydrogène, C₁₋₅ alkyle ou C₆₋₁₀ aryle linéaire ou ramifié ; éventuellement les groupements C₁₋₅ alkyle de R₂₁ et R₂₂ peuvent se lier les uns aux autres pour former un cycle saturé ou insaturé ; éventuellement un ou plusieurs parmi les groupements méthylène d'un tel cycle saturé peuvent être chacun indépendamment remplacés par -(C=O)- ou -NR₂₅- ; où R₂₅ est chacun dépendamment hydrogène, C₁₋₅ alkyle ou C₆₋₁₀ aryle linéaire ou ramifié ;
m₂₁ est un nombre entier valant 1-3 ; et
R₂₃ et R₂₄ sont chacun indépendamment C₁₋₁₀ alkyle, C₆₋₁₈ aryle, C₆₋₁₂ aryl C₁₋₅ alkyle, ou C₁₋₅ alkyl C₆₋₁₂ aryle ; où la partie alkyle de R₂₃ et R₂₄ peut être linéaire ou ramifiée, chacune indépendamment ; et éventuellement le groupement méthylène de la partie alkyle de R₂₃ et R₂₄ peut être remplacé par -CO-, -O-, ou -COO- ; 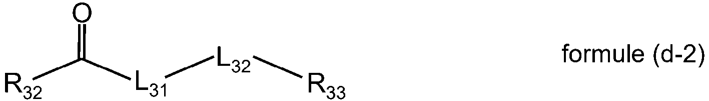
dans laquelle R₃₂ et R₃₃ sont chacun indépendamment des groupements hydrocarbonés en C₁₋₂₁ qui peuvent éventuellement former un cycle saturé ou insaturé, où éventuellement une ou plusieurs parties de la liaison simple carbone-carbone dans le composé représenté par la formule (d-2) (plus préférablement R₃₂ ou R₃₃) peuvent être remplacées par une double liaison carbone-carbone ; éventuellement la partie méthylène de R₃₂ peut être remplacée par -O- ou -C(=O)- ;
L₃₁ est un bras de liaison hydrocarboné en C₁₋₁₂ qui peut éventuellement former un cycle saturé ou insaturé, où éventuellement une partie méthylène de L₃₁ peut être remplacée par -O- ;
L₃₂ est -CO-, -CH₂-, ou -CH(CH₃)- ; et
au moins l'un parmi les groupements méthyle dans le composé représenté par la formule (d-2) est remplacé par hydroxyle ou méthoxy ; 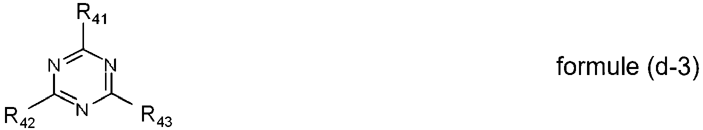
dans laquelle R₄₁, R₄₂ et R₄₃ sont chacun indépendamment des groupements hydrocarbonés en C₁₋₂₀ qui peuvent éventuellement former un cycle saturé ou insaturé, où éventuellement la partie méthylène de R₄₁, R₄₂ ou R₄₃ peut être remplacée par -O- ; où au moins l'un parmi les groupements méthyle dans le composé représenté par la formule (d-3) est remplacé par hydroxyle ou méthoxy.

2. Composition selon la revendication 1, ladite composition formant une couche sensiblement transparente lors de son exposition à un rayonnement approprié ;
préférablement la couche sensiblement transparente présente une transmission moyenne de 80-99,9% d'une lumière de longueur d'onde de 450-800 nm ; ou
préférablement la couche sensiblement transparente présente une transmission moyenne de 5-60% d'une lumière de longueur d'onde dans la gamme de 250-450 nm.

3. Composition selon la revendication 1 ou 2, dans laquelle ladite couche sensiblement transparente présente une transmission moyenne de 90-100% de la lumière visible.

4. Composition selon la revendication 1, dans laquelle le composé absorbant (d) est un composé choisi dans le groupe constitué par les amines tertiaires aromatiques contenant au moins deux motifs amine tertiaire, les amines tertiaires contenant des motifs carbazole, les composés d'hexa-aza-triphénylène et les dérivés de phtalocyanine et est excité par un champ électronique lorsqu'il forme (préférablement par dépôt) la couche.

5. Composition selon la revendication 1, dans laquelle le composé absorbant (d) est représenté par une formule choisie dans le groupe constitué par les formules (d-1), (d-2) et (d-3) suivantes, et le composé absorbant (d) agit pour bloquer les UV par un mécanisme de transfert intramoléculaire de protons à l'état excité (ESIPT).

6. Composition selon l'une ou plusieurs parmi les revendications 1-5, dans laquelle le monomère (a) de formule (I) répond à la formule (I-a) 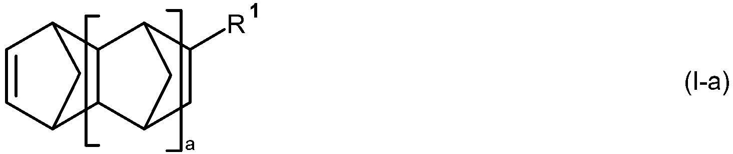 dans laquelle a vaut 0 ou 1, et R¹ est un groupement C₁₋₂₀ alkyle linéaire ou ramifié ou un groupement C₆₋₁₀ aryl C₁₋₆ alkyle non substitué.

7. Composition selon l'une ou plusieurs parmi les revendications 1-6, dans laquelle le monomère (a) de formule (I) est choisi dans le groupe constitué par les formules (I-a-01) à (I-a-21) suivantes :
| | | |
|---|---|---|
| 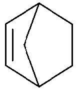 | NB | (I-a-01) |
| 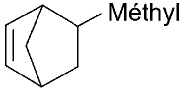 | MeNB | (I-a-02) |
| 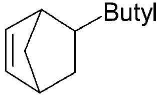 | BuNB | (I-a-03) |
| 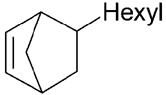 | HexNB | (I-a-04) |
| 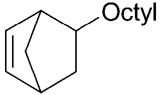 | OctNB | (I-a-05) |
| 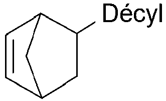 | DecNB | (I-a-06) |
| 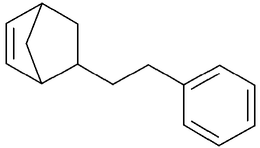 | PENB | (I-a-07) |
| 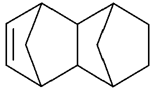 | TD | (I-a-08) |
| 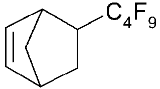 | NBC₄F₉ | (I-a-09) |
| 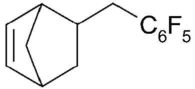 | NBCH₂C₆F₅ | (I-a-10) |
| 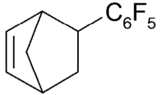 | NBC₆F₅ | (I-a-11) |
| 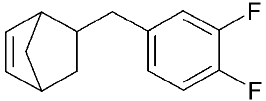 | NBCH₂C₆H₃F₂ | (I-a-12) |
| 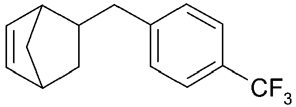 | NBCH₂C₆H₄CF₃ | (I-a-13) |
| 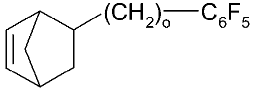 | NBalkylC₆F₅ | (I-a-14) |
| 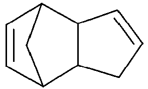 | DCPD | (I-a-15) |
| 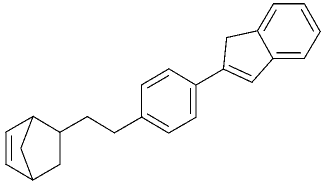 | EtPhlndNB | (I-a-16) |
| 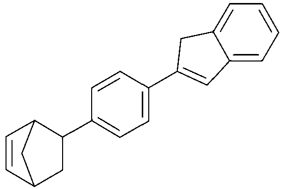 | PhIndNB | (I-a-17) |
| 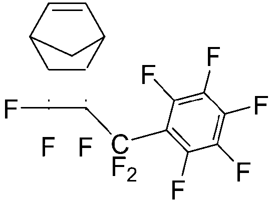 | PFBTCNB | (I-a-18) |
| | PMNB | (I-a-19) |
| 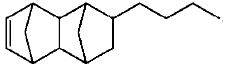 | ButylTD | (I-a-20) |
| 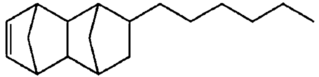 | HexylTD | (I-a-21) |
| 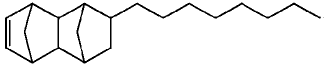 | OctylTD | (I-a-22) |

8. Composition selon l'une ou plusieurs parmi les revendications 1-7, dans laquelle le catalyseur latent est un composé d'organo-ruthénium choisi dans le groupe constitué par un composé de formule (IIA), un composé de formule (IIB), un composé de formule (IIIA), un composé de formule (IIIB), un composé de formule (IIIC), et un composé de formule (IIID) : 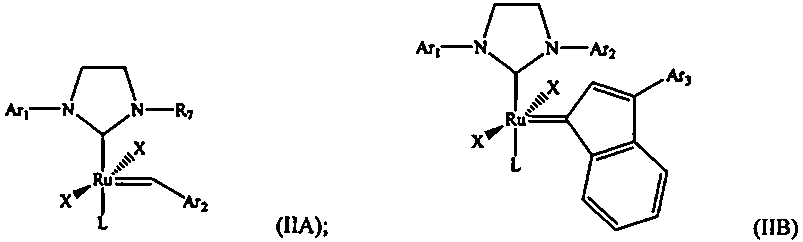 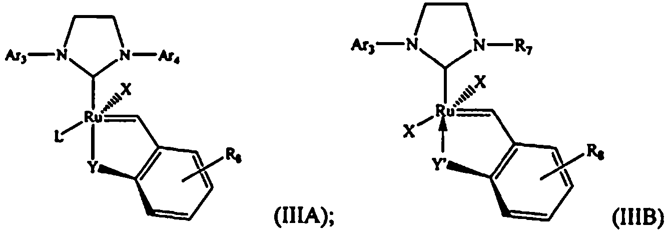 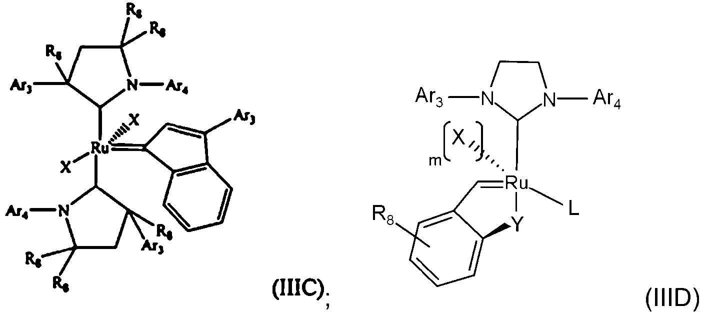 dans lesquelles :
X est choisi chacun indépendamment dans le groupe constitué par chlore, brome, iode, -ORₐ, -O(CO)Rₐ, -S(Rₐ)₂, -OSO₂Rₐ et -N(Rₐ)₂, où Rₐ est choisi chacun indépendamment dans le groupe constitué par une liaison simple, C₁₋₁₂ alkyle, C₃₋₁₂ cycloalkyle, C₆₋₁₄ aryle et =CH(Rₐ') ;
où toute combinaison de deux combinaisons Rₐ peuvent être liées les unes aux autres ; et Rₐ' est une liaison simple qui est liée à Rₐ ou L,
Y est choisi dans le groupe constitué par O, S et NCOCF₃ ;
Y' est choisi dans le groupe constitué par OR₉, SR₉ et -N=CHC(O)O(C₁₋₆ alkyl), où R₉ est choisi dans le groupe constitué par méthyle, éthyle, C₁₋₆ alkyle linéaire ou ramifié, C₆₋₁₀ aryle, méthoxy, éthoxy, C₁₋₆ alcoxy linéaire ou ramifié, C₆₋₁₀ aryloxy et -OCH(CH₃)C(O)N(CH₃)(OCH₃) ;
L est choisi dans le groupe constitué par pyridine, PR₃, O=PR₃ et -O-R₃, où chaque R₃ est choisi indépendamment dans le groupe constitué par isopropyle, sec-butyle, tertio-butyle, cyclohexyle, bicyclo C₅₋₁₀ alkyle, phényle, benzyle, isopropoxy, sec-butoxy, tertio-butoxy, cyclohexyloxy, phénoxy et benzyloxy ;
où l'un parmi X et L peut former un ligand anionique de formule X-L ;
R₇ est choisi dans le groupe constitué par isopropyle, sec-butyle, tertio-butyle, cyclohexyle substitué ou non substitué, phényle substitué ou non substitué, biphényle substitué ou non substitué et naphtyle substitué ou non substitué ;
R₈ est choisi dans le groupe constitué par hydrogène, chlore, méthyle, éthyle, C₁₋₆ alkyle linéaire ou ramifié, C₆₋₁₀ aryle, méthoxy, éthoxy, C₁₋₆ alcoxy linéaire ou ramifié, C₆₋₁₀ aryloxy, -NHCO(C₁₋₆)alkyle, -NHCOperfluoro(C₁₋₆)alkyle, -SO₂N((C₁₋₆)alkyl)₂ et -NO₂ ;
Ar₁, Ar₂, Ar₃ et Ar₄ sont choisis chacun indépendamment dans le groupe constitué par phényle substitué ou non substitué, biphényle substitué ou non substitué et naphtyle substitué ou non substitué ;
où lesdits substituants sont choisis chacun indépendamment dans le groupe constitué par méthyle, éthyle, isopropyle, tertio-butyle, phényle et OSi(SiMe₃)₃ ;
m est un nombre entier valant 1, 2 ou 3.

9. Composition selon l'une ou plusieurs parmi les revendications 1-8, dans laquelle la teneur en monomère (a) est de 80-99,99% en masse sur la base de la composition ;
préférablement la teneur en catalyseur latent organométallique à base de métal de transition (b) est de 0,0001-1,0% en masse sur la base de la composition ;
préférablement la teneur en composé capable de libérer un acide de Brønsted (c) est de 0,0001-1,0% en masse sur la base de la composition ; ou
préférablement la teneur en composé absorbant (d) est de 0,5-15% en masse sur la base de la composition.

10. Méthode de fabrication d'une couche de polycyclooléfine, comprenant les étapes ;
(1) de préparation d'un élément de base ;
(2) d'application de la composition selon l'une ou plusieurs quelconques parmi les revendications 1 à 9 au-dessus de l'élément de base ; et
(3) de polymérisation des monomères (a) dans la composition.

11. Méthode de fabrication d'une couche de polycyclooléfine selon la revendication 10 ; dans laquelle la permittivité de la couche de polycyclooléfine est de 3 ou moins.

12. Méthode de fabrication d'une couche de polycyclooléfine selon la revendication 10 ou 11 ; dans laquelle la mesure d'application de la composition dans l'étape (2) est choisie dans le groupe constitué par le dépôt, le dépôt par immersion, le dépôt par centrifugation, l'impression à jet d'encre, l'impression à buse, l'impression typographique, la sérigraphie, l'impression héliographique, le revêtement à racle, l'impression au rouleau, l'impression au rouleau inversé, l'impression lithographique offset, l'impression lithographique offset à sec, l'impression flexographique, l'impression à bande, le revêtement par pulvérisation, le revêtement au rideau, le revêtement au pinceau, le revêtement par fente et la tampographie ; et
préférablement le dépôt, l'impression à jet d'encre ou l'impression à buse.

13. Méthode de fabrication d'une couche de polycyclooléfine selon l'une ou plusieurs quelconques parmi les revendications 10 à 12 ; dans laquelle l'étape (3) est réalisée par irradiation et/ou par chaleur.

14. Méthode de fabrication d'une couche de polycyclooléfine selon l'une ou plusieurs quelconques parmi les revendications 10 à 13 ; comprenant en outre l'étape
(4) d'application d'une ou plusieurs couches supplémentaires au-dessus de la couche de polycyclooléfine ;
préférablement les couches supplémentaires sont choisies dans le groupe constitué par les couches organiques, les couches inorganiques et les couches hybrides ;
préférablement les couches supplémentaires sont choisies dans le groupe constitué par une couche inorganique comprenant un matériau choisi dans le groupe constitué par l'oxyde de silicium, le nitrure de silicium, l'oxynitrure de silicium, l'oxynitrure d'aluminium, l'oxyde de magnésium, l'oxyde d'aluminium, le nitrure d'aluminium, l'oxyde de titane, le nitrure de titane, l'oxyde de tantale, le nitrure de tantale, l'oxyde de hafnium, le nitrure de hafnium, l'oxyde de zirconium, le nitrure de zirconium, l'oxyde de cérium, le nitrure de cérium, l'oxyde d'étain, le nitrure d'étain et un mélange quelconque de ceux-ci ; ou préférablement les couches supplémentaires constituant un écran tactile.

15. Méthode de fabrication d'un dispositif électronique, comprenant ;
une méthode de fabrication d'une couche de polycyclooléfine selon l'une ou plusieurs quelconques parmi les revendications 10 à 14.

16. Méthode de fabrication d'un dispositif électronique selon la revendication 15, dans laquelle l'élément de base de la méthode de fabrication d'une polycyclooléfine est un dispositif électronique ;
préférablement le dispositif électronique est un dispositif électroluminescent (plus préférablement un dispositif électroluminescent organique) ;
préférablement le dispositif électroluminescent comprend en séquence une première électrode (plus préférablement une anode), une couche électroluminescente, et une deuxième électrode (plus préférablement une cathode) ; ou
préférablement le dispositif électroluminescent organique comprend en séquence une première électrode (plus préférablement une anode),
une couche de transport de trous, une couche électroluminescente, une couche de transport d'électrons, et la deuxième électrode (plus préférablement une cathode).

17. Dispositif électronique fabriqué par la méthode selon la revendication 15 ou 16.
